# EUROPEAN PATENT SPECIFICATION

(11) **EP 4 560 159 B1**
(45) Date of publication and mention of the grant of the patent: **11.11.2026**
(21) Application number: 23924912.1
(22) Date of filing: 20.09.2023
(51) Int. Cl.: F16C 11/12, G06F 1/16, H04M 1/02, G09F 9/30, H05K 5/02

(54) **ROTATING SHAFT MECHANISM AND ELECTRONIC DEVICE**
DREHWELLENMECHANISMUS UND ELEKTRONISCHE VORRICHTUNG
MÉCANISME D'ARBRE ROTATIF ET DISPOSITIF ÉLECTRONIQUE

(30) Priority: 27.02.2023 CN 202310209056
(43) Date of publication of application: 28.05.2025
(73) Proprietor: Huawei Technologies Co., Ltd., Shenzhen, Guangdong 518129 (CN)
(72) Inventor: LIN, Yangming, Shenzhen, Guangdong 518129 (CN); CHENG, Zhengshu, Shenzhen, Guangdong 518129 (CN); ZHANG, Haifeng, Shenzhen, Guangdong 518129 (CN); WANG, Song, Shenzhen, Guangdong 518129 (CN)
(74) Representative: Pfenning, Meinig & Partner mbB
(86) International application number: PCT/CN2023/119927
(87) International publication number: WO 2024/178958

(56) References cited:
- EP-A1- 4 089 990
- WO-A1-2021/115462
- CN-A- 115 217 838
- CN-U- 215 805 720
- CN-U- 217 428 168

## Description

### TECHNICAL FIELD

This application relates to the field of electronic device technologies, and in particular, to a hinge mechanism and an electronic device.

### BACKGROUND

As flexible display technologies gradually mature, display manners of electronic devices are driven to change greatly. A mobile phone having a foldable flexible display, a tablet computer having a foldable flexible display, a wearable electronic device having a foldable flexible display, and the like are an important evolution direction of intelligent electronic devices in the future.

A hinge mechanism, as a key component for implementing folding and unfolding functions of a foldable electronic device, needs to provide sufficient space in a folded state of the electronic device to accommodate a bent part of a flexible display, and can reliably support the flexible display in an unfolded state of the electronic device. However, in the existing folding solution, when the foregoing two conditions are met, the hinge mechanism has a specific weakness in movement control accuracy, affecting overall reliability of the electronic device.

CN115217838A discloses a folding electronic device including a housing, a folding apparatus, and a flexible display.

### SUMMARY

This application provides a hinge mechanism and an electronic device, to improve movement accuracy of the hinge mechanism, and further improve overall reliability of the electronic device.

According to a first aspect, this application provides a hinge mechanism. The hinge mechanism may include a first rotation module, a second rotation module, and a module bracket. The first rotation module and the second rotation module may be respectively disposed on two sides of the module bracket. The first rotation module may include a first swing arm, a first support arm, a first housing support, a first door plate, and a first connecting rod, the first door plate may be configured to support a flexible display, at least a part of the first swing arm and at least a part of the second support arm may be disposed on a surface that is of the first door plate and that is away from the flexible display, the first swing arm and the first support arm may be distributed in a length direction of the hinge mechanism, the first swing arm and the first support arm are separately rotatably connected to the module bracket, and a rotation axis center of the first support arm and a rotation axis center of the first swing arm on the module bracket are different from each other and parallel to each other. At least a part of the first housing support may be disposed on a surface that is of the first swing arm and that is away from the first door plate and a surface that is of the first support arm and that is away from the first door plate, the first swing arm is rotatably connected to the first housing support, the first support arm is slidably connected to the first housing support, and the first door plate is rotatably connected to the first housing support. One end of the first connecting rod may be rotatably connected to the first swing arm, and the other end of the first connecting rod may be rotatably connected to the first door plate. The second rotation module may include a second swing arm, a second support arm, a second housing support, a second door plate, and a second connecting rod, the second door plate may be configured to support the flexible display, the second swing arm and the second support arm may be distributed in the length direction of the hinge mechanism, the second swing arm and the second support arm are separately rotatably connected to the module bracket, and a rotation axis center of the second support arm and a rotation axis center of the second swing arm on the module bracket are different from each other and parallel to each other. At least a part of the second housing support may be disposed on a surface that is of the second swing arm and that is away from the second door plate and a surface that is of the second support arm and that is away from the second door plate, the first swing arm is rotatably connected to the second housing support, the second support arm is slidably connected to the second housing support, and the second door plate is rotatably connected to the second housing support. One end of the second connecting rod may be rotatably connected to the second swing arm, and the other end of the second connecting rod may be rotatably connected to the second door plate. In this way, when the first housing support and the second housing support rotate relative to each other, the first housing support may drive the first support arm and the first swing arm to rotate around the module bracket, and the first connecting rod drives the first door plate to rotate relative to the first housing support, for one end that is of the first door plate and that is close to the module bracket to move in a direction away from the module bracket. Correspondingly, the second housing support may drive the second support arm and the second swing arm to rotate around the module bracket, and the second connecting rod drives the second door plate to rotate relative to the second housing support, for one end that is of the second door plate and that is close to the module bracket to move in a direction away from the module bracket. In this way, when the first door plate rotates to a first position and the second door plate rotates to a second position, the first door plate and the second door plate form an included angle, and jointly enclose, with the module bracket, screen accommodating space used to accommodate the flexible display. Specifically, the first position herein is a position at which the first door plate and the second door plate stay when an electronic device is in a folded state. At this position, the included angle between the first door plate and the second door plate is an acute angle. It should be noted that the included angle herein may be an included angle directly formed by the first door plate and the second door plate, or may be an included angle formed by extension lines of the first door plate and the second door plate.

In the foregoing solution, the first swing arm, the first housing support, the first door plate, and the first connecting rod may roughly form a four-bar linkage mechanism based on rotation connection relationships between the first swing arm and the first housing support, between the first housing support and the first door plate, between the first door plate and the first connecting rod, and between the first connecting rod and the first swing arm. In this case, the first door plate can rotate under common constraint of the first connecting rod and the first housing support. Similarly, the second swing arm, the second housing support, the second door plate, and the second connecting rod may also roughly form a four-bar linkage mechanism, and the second door plate can rotate under common constraint of the second connecting rod and the second housing support. This design can effectively improve movement accuracy of the hinge mechanism in unfolding and folding processes, and improve force-bearing statuses of the first door plate and the second door plate, so that the first door plate and the second door plate can stably and accurately move to specified positions. Further, reliability of an overall structure of the electronic device in which the hinge mechanism is used can be improved.

In some possible implementation solutions, the first rotation module may further include a third door plate, and the third door plate may be located on a side that is of the first door plate and that is close to the module bracket, to jointly support the flexible display with the first door plate. The third door plate may be rotatably connected to the first door plate, the third door plate may be slidably connected to the module bracket, and the third door plate is capable of rotating relative to the module bracket. Similarly, the second rotation module may further include a fourth door plate, and the fourth door plate may be located on a side that is of the second door plate and that is close to the module bracket, to jointly support the flexible display with the second door plate. The fourth door plate may be rotatably connected to the second door plate, the fourth door plate may be slidably connected to the module bracket, and the fourth door plate is capable of rotating relative to the module bracket. The hinge mechanism is designed in a structural form of four door plates. In the folded state, the screen accommodating space formed in the hinge mechanism can better fit a bending form of the flexible display. This helps improve reliability of the flexible display.

In some possible implementation solutions, a surface that is of the first swing arm and that faces the first door plate may be provided with a first mounting groove, a surface that is of the first door plate and that faces the first swing arm may be provided with a second mounting groove, one end of the first connecting rod is rotatably disposed in the first mounting groove, and the other end of the first connecting rod is rotatably disposed in the second mounting groove. In this way, the first connecting rod is rotatably connected to the first swing arm and the first door plate. Similarly, a surface that is of the second swing arm and that faces the second door plate may be provided with a third mounting groove, a surface that is of the second door plate and that faces the second swing arm may be provided with a fourth mounting groove, one end of the second connecting rod is rotatably disposed in the third mounting groove, and the other end of the second connecting rod is rotatably disposed in the fourth mounting groove. In this way, the second connecting rod is rotatably connected to the second swing arm and the second door plate.

In some possible implementation solutions, the surface that is of the first door plate and that is away from the flexible display may be provided with a first bump, the first bump may be located on a side of the first support arm in the length direction of the hinge mechanism, a side surface that is of the first bump and that faces the first support arm may be provided with a first rotary sliding groove, a side surface that is of the first support arm and that faces the first bump is provided with a first sliding shaft, and the first sliding shaft may be slidably disposed in the first rotary sliding groove. In this way, the first door plate support and the first support arm can rotate relative to each other through cooperation between the first sliding shaft and the first rotary sliding groove. Similarly, the surface that is of the second door plate and that is away from the flexible display may be provided with a second bump, the second bump may be located on a side of the second support arm in the length direction of the hinge mechanism, a side surface that is of the second bump and that faces the second support arm may be provided with a second rotary sliding groove, a side surface that is of the first support arm and that faces the second bump is provided with a second sliding shaft, and the second sliding shaft may be slidably disposed in the second rotary sliding groove. In this way, the second door plate support and the second support arm can rotate relative to each other through cooperation between the second sliding shaft and the second rotary sliding groove.

In some possible implementation solutions, the two sides of the module bracket may be respectively provided with a first arc-shaped groove and a second arc-shaped groove. The first swing arm may have a first arc-shaped rotation block, and the first arc-shaped rotation block is disposed in the first arc-shaped groove, and can rotate around an arc-shaped surface of the first arc-shaped groove, so that the first swing arm rotates around the module bracket. The second swing arm may have a second arc-shaped rotation block, and the second arc-shaped rotation block is disposed in the second arc-shaped groove, and can rotate around an arc-shaped surface of the second arc-shaped groove, so that the second swing arm rotates around the module bracket.

In some possible implementation solutions, the first housing support may be provided with a first sliding groove, and the first support arm is slidably disposed in the first sliding groove, so that the first housing support is slidably connected to the first support arm. Similarly, the second housing support may be provided with a second sliding groove, and the second support arm is slidably disposed in the second sliding groove, so that the second housing support is slidably connected to the second support arm.

In addition, a groove wall of the first sliding groove may be further provided with a first sliding rail, a side surface of the first support arm may be provided with a first sliding block, and the first sliding block may be slidably disposed in the first sliding rail. In this way, the first support arm can be limited in the first sliding groove, and the first sliding groove is used to guide sliding of the first support arm in the first sliding groove, to improve movement stability of the first support arm. Similarly, a groove wall of the second sliding groove may be provided with a second sliding rail, a side surface of the second support arm may be provided with a second sliding block, and the second sliding block may be slidably disposed in the second sliding rail. In this way, the second support arm can be limited in the second sliding groove, and the second sliding groove is used to guide sliding of the second support arm in the second sliding groove, to improve movement stability of the second support arm.

In some possible implementation solutions, the first housing support may be provided with a third arc-shaped rotation block, the first door plate may be provided with a third arc-shaped groove, and the third arc-shaped rotation block may be rotatably disposed in the third arc-shaped groove. In this way, the first housing support is rotatably connected to the first door plate. The second housing support may be provided with a fourth arc-shaped rotation block, the second door plate may be provided with a fourth arc-shaped groove, and the fourth arc-shaped rotation block may be rotatably disposed in the fourth arc-shaped groove. In this way, the second housing support is rotatably connected to the second door plate.

In some possible implementation solutions, a surface that is of the third door plate and that is away from the flexible display is provided with a fifth arc-shaped rotation block, the surface that is of the first door plate and that is away from the flexible display is provided with a fifth arc-shaped groove, and the fifth arc-shaped rotation block is rotatably disposed in the fifth arc-shaped groove. In this way, the first door plate is rotatably connected to the third door plate. A surface that is of the fourth door plate and that is away from the flexible display is provided with a sixth arc-shaped rotation block, the surface that is of the second door plate and that is away from the flexible display is provided with a sixth arc-shaped groove, and the sixth arc-shaped rotation block is rotatably disposed in the sixth arc-shaped groove. In this way, the second door plate is rotatably connected to the fourth door plate.

In some other possible implementation solutions, the first door plate may alternatively be connected to the third door plate via a first flexible component. In this case, the first door plate and the third door plate may rotate relative to each other through deformation of the first flexible component. Similarly, the second door plate and the fourth door plate may be connected via a second flexible component, to rotate relative to each other through deformation of the second flexible component.

Optionally, the first flexible component may be disposed on a surface that is of the first door plate and that is away from the flexible display and a surface that is of the third door plate and that is away from the flexible display, and the first flexible component is bonded to the first door plate and the third door plate separately. The second flexible component may be disposed on a surface that is of the second door plate and that is away from the flexible display and a surface that is of the fourth door plate and that is away from the flexible display, and the second flexible component is bonded to the second door plate and the fourth door plate separately.

For example, in the foregoing solution, the first flexible component and the second flexible component may be made of a material like carbon fiber and Kevlar.

Optionally, the first flexible component may be connected between the first door plate and the third door plate. In this case, the first door plate and the third door plate may be of an integrated structure, and the deformable first flexible component is formed by performing thinning processing at a joint between the first door plate and the third door plate. Similarly, the second flexible component may be connected between the second door plate and the fourth door plate. In this case, the second door plate and the fourth door plate may be of an integrated structure, and the second flexible component may be formed by performing thinning processing a joint between the second door plate and the fourth door plate.

In some possible implementation solutions, two sides of an end part of the module bracket may be respectively provided with a first track groove and a second track groove. The surface that is of the third door plate and that is away from the flexible display may be provided with a first extension wall, the first extension wall may be provided with a first fastening shaft disposed in the length direction of the hinge mechanism, and the first fastening shaft may be slidably disposed in the first track groove. In this way, the third door plate is rotatably connected to the module bracket. The surface that is of the fourth door plate and that is away from the flexible display may be provided with a second extension wall, the second extension wall may be provided with a second fastening shaft disposed in the length direction of the hinge mechanism, and the second fastening shaft may be slidably disposed in the second track groove. In this way, the fourth door plate is rotatably connected to the module bracket.

In some possible implementation solutions, the first door plate may include a first door plate body and a first door plate support, and the first door plate body may be fastened to a surface that is of the first door plate support and that faces the flexible display, to support the flexible display. The second door plate may include a second door plate body and a second door plate support, and the second door plate body may be fastened to a surface that is of the second door plate support and that faces the flexible display, to support the flexible display. The first door plate and the second door plate each are designed in a structural form in which the door plate support and the door plate body are separated. This helps reduce processing difficulty of the first door plate and the second door plate, and reduce manufacturing costs of the first door plate and the second door plate.

In an optional solution, the first door plate body may be fastened to the first door plate support through welding, press riveting, or the like, and the second door plate body may also be fastened to the second door plate support through welding, press riveting, or the like.

In another optional solution, the first door plate body and the first door plate support may be of an integrated structure, and the second door plate body and the second door plate support may also be of an integrated structure. This helps simplify structures of the first door plate and the second door plate. In this way, an overall structure of the hinge mechanism is simplified, and assembly difficulty of the hinge mechanism is reduced.

In some possible implementation solutions, the hinge mechanism may further include a base, and the module bracket may be fastened to the base. In this way, the module bracket is supported via the base.

In an optional solution, the base may be supported on a surface that is of the module bracket and that is away from the first door plate and the second door plate.

In another optional solution, the base may alternatively be disposed between the first door plate and the second door plate. When the hinge mechanism is in an unfolded state, a surface that is of the base and that is away from the module bracket is coplanar with a surface that is of the first door plate and that is away from the first swing arm and a surface that is of the second door plate and that is away from the second swing arm. In this case, the base, the first door plate, and the second door plate may jointly support the flexible display. This improves reliability of the flexible display.

In some possible implementation solutions, the hinge mechanism may further include a synchronization assembly, the synchronization assembly may include a first drive gear disposed at an end of the first support arm and a second drive gear disposed at an end of the second support arm, and the two drive gears are engaged. In this way, when one support arm rotates around the base, the other support arm can be driven to synchronously rotate at a same angle in a direction toward or away from the one support arm.

In addition, the synchronization assembly may further include even-numbered driven gears, and the even-numbered driven gears may be disposed between the two drive gears, so that the two drive gears synchronously rotate via the even-numbered driven gears. This helps improve stability of movement of the synchronization assembly, and further improve reliability of synchronous rotation of the two support arms.

According to a second aspect, this application further provides an electronic device. The electronic device may include a first housing, a second housing, a flexible display, and the hinge mechanism according to any possible implementation of the first aspect. The first housing and the second housing may be respectively disposed on two sides of the hinge mechanism, the first housing is fastened to the first housing support, and the second housing is fastened to the second housing support. The flexible display may continuously cover the first door plate, the second door plate, and the hinge mechanism, and the flexible display is fastened to the first door plate and the second door plate.

According to the electronic device provided in this application, when the electronic device is in an unfolded state, the hinge mechanism may provide flat support for the flexible display, to ensure that a form of the electronic device in the unfolded state is complete. When the electronic device is in a folded state, the hinge mechanism may form water drop-like screen accommodating space, to meet a bending requirement of the flexible display. This reduces a risk of extrusion or stretching of the flexible display. When the electronic device is switched between the unfolded state and the folded state, the first swing arm, the first housing support, the first door plate, and the first connecting rod of the first rotation module may form a four-bar linkage mechanism, and the second swing arm, the second housing support, the second door plate, and the second connecting rod of the second rotation module may also form a four-bar linkage mechanism, so that movement accuracy of the electronic device in unfolding and folding processes is improved by using movement characteristics of the four-bar linkage mechanisms on the two sides. In this way, reliability of the entire electronic device is improved.

### BRIEF DESCRIPTION OF DRAWINGS

FIG. 1 is a diagram of a structure of an electronic device according to an embodiment of this application;
FIG. 2 is a diagram of a partial exploded structure of the electronic device shown in FIG. 1;
FIG. 3 is a diagram of a partial structure of a main shaft unit according to an embodiment of this application;
FIG. 4 is a diagram of an exploded structure of the main shaft unit shown in FIG. 3;
FIG. 5 is a diagram of a partial structure of a hinge mechanism in an unfolded state according to an embodiment of this application;
FIG. 6 is a diagram of a partial exploded structure of a hinge mechanism in an unfolded state according to an embodiment of this application;
FIG. 7 is a diagram of a structure of a first swing arm according to an embodiment of this application;
FIG. 8 is a diagram of a structure of a first housing support according to an embodiment of this application;
FIG. 9 is a diagram of a structure of a first support arm according to an embodiment of this application;
FIG. 10 is a diagram of a partial structure of a main shaft unit according to an embodiment of this application;
FIG. 11 is a diagram of a structure of a first door plate support according to an embodiment of this application;
FIG. 12 is a diagram of a structure of a first connecting rod according to an embodiment of this application;
FIG. 13 is a sectional view of a partial structure of a hinge mechanism according to an embodiment of this application;
FIG. 14 is a diagram of a structure of a first sub-board and a second sub-board according to an embodiment of this application;
FIG. 15 is a sectional view of a partial structure of a hinge mechanism in an intermediate state according to an embodiment of this application;
FIG. 16 is a sectional view of another partial structure of a hinge mechanism in an intermediate state according to an embodiment of this application;
FIG. 17 is a diagram of a partial structure of a hinge mechanism in an unfolded state according to an embodiment of this application;
FIG. 18 is a diagram of a partial structure of a hinge mechanism in an intermediate state according to an embodiment of this application;
FIG. 19 is a diagram of a partial structure of a hinge mechanism in a folded state according to an embodiment of this application;
FIG. 20 is a diagram of another structure of a first sub-board and a second sub-board according to an embodiment of this application;
FIG. 21 is another diagram of a structure of a first sub-board and a second sub-board according to an embodiment of this application;
FIG. 22 is a diagram of another structure of a second sub-board according to an embodiment of this application;
FIG. 23 is a diagram of a partial structure of another hinge mechanism according to an embodiment of this application;
FIG. 24 is a sectional view of the hinge mechanism shown in FIG. 23;
FIG. 25 is a diagram of a partial structure of a hinge mechanism according to an embodiment of this application; and
FIG. 26 is a sectional view of the hinge mechanism shown in FIG. 25 at A-A.

### Reference numerals:

1: hinge mechanism; 1a: support surface of the hinge mechanism;
11: main shaft unit; 111: module bracket; 1111: swing arm support; 11111: first arc-shaped groove; 11112: first track groove;
11113: second arc-shaped groove; 11114: second track groove; 1112: damping support; 1113: pin shaft; 112: first rotation module;
1121: first swing arm; 11211: first arc-shaped rotation block; 11211a: first rotation sub-block; 11211b: second rotation sub-block;
11212: first mounting groove; 1122: first support arm; 11221: first sliding block; 11222: sliding shaft; 1123: first housing support;
11231: first open slot; 11232: first sliding groove; 112321: first sliding rail; 11233: third arc-shaped rotation block; 1124: first door plate;
11241: first door plate support; 112411: second mounting groove; 112412: third arc-shaped groove; 112413: bump; 1124131: rotary sliding groove;
11242: third door plate; 112421: first extension wall; 1124211: first fastening shaft; 112422: fifth arc-shaped rotation block;
11243: first door plate body; 112431: fifth arc-shaped groove; 11244: first flexible component; 1125: first connecting rod;
113: second rotation module; 1131: second swing arm; 11311: second arc-shaped rotation block; 11312: third mounting groove; 1132: second support arm;
1133: second housing support; 11331: second open slot; 11332: second sliding groove; 11333: fourth arc-shaped rotation block; 1134: second door plate;
11341: second door plate support; 113411: fourth mounting groove; 113412: fourth arc-shaped groove; 11342: fourth door plate;
113421: sixth arc-shaped rotation block; 11343: second door plate body; 113431: sixth arc-shaped groove; 1135: second connecting rod;
114: damping assembly; 1141: elastic member; 1142: conjoined cam; 1114: intermediate shaft; 115: synchronization assembly; 1151: first drive gear;
1152: second drive gear; 1153: driven gear;
12: base; 13: cover;
2: first housing; 2a: support surface of the first housing; 201: first accommodating groove;
3: second housing; 3a: support surface of the second housing; and 301: second accommodating groove.

### DESCRIPTION OF EMBODIMENTS

To make the objectives, technical solutions, and advantages of this application clearer, the following further describes the embodiments of this application in detail with reference to the accompanying drawings. However, example implementations can be implemented in a plurality of forms, and should not be construed as being limited to the implementations described herein. Identical reference numerals in the accompanying drawings denote identical or similar structures. Therefore, repeated descriptions thereof are omitted. Expressions of positions and directions in embodiments of this application are described by using the accompanying drawings as an example. However, changes may be also made as required, and all the changes fall within the protection scope of this application. The accompanying drawings in embodiments of this application are merely used to illustrate a relative position relationship and do not represent an actual scale.

It should be noted that specific details are provided in the following descriptions for ease of understanding this application. However, embodiments of this application can be implemented in a plurality of manners different from those described herein, and a person skilled in the art can perform similar promotion without departing from the connotation of embodiments of this application. Therefore, this application is not limited to the specific implementations disclosed below.

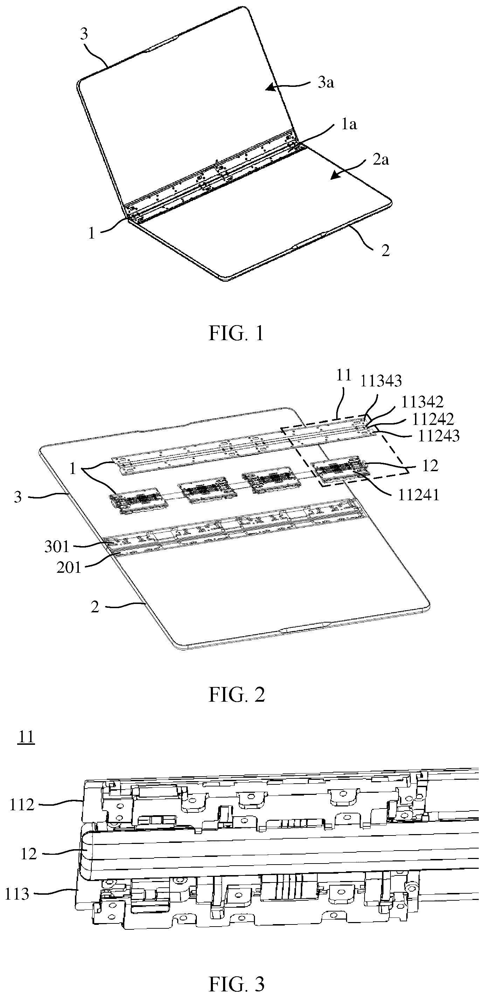

FIG. 1 is a diagram of a structure of an electronic device according to an embodiment of this application. The electronic device may be a mobile phone, a palmtop computer (personal digital assistant, PDA), a notebook computer, a tablet computer, or another device with a foldable function. An example in which the electronic device in the embodiment shown in FIG. 1 is a notebook computer is used for description. The electronic device may include a hinge mechanism 1, a flexible display (not shown in the figure), and two housings. For ease of description, the two housings may be respectively named a first housing 2 and a second housing 3. The first housing 2 and the second housing 3 are located on two sides of the hinge mechanism 1, and can rotate around the hinge mechanism 1. When the electronic device is used, the electronic device may be folded or unfolded in different use scenarios. The electronic device provided in this embodiment of this application may be an inward foldable electronic device. In the embodiment shown in FIG. 1, the electronic device is in an intermediate state between a folded state and an unfolded state, and structures of a support surface 1a of the hinge mechanism 1, a support surface 2a of the first housing 2, and a support surface 3a of the second housing 3 are shown. Herein, the support surface 1a of the hinge mechanism 1 is a surface that is of the hinge mechanism 1 and that is configured to support the flexible display, the support surface 2a of the first housing 2 is a surface that is of the first housing 2 and that is configured to support the flexible display, and the support surface 3a of the second housing 3 is a surface that is of the second housing 3 and that is configured to support the flexible display.

The flexible display may continuously cover the support surface 2a of the first housing 2, the support surface 1a of the hinge mechanism, and the support surface 3a of the second housing 3, and the flexible display may be fastened to the support surface 2a of the first housing 2 and the support surface 3a of the second housing 3. A connection manner may be but is not limited to bonding. In this way, when the electronic device is in the unfolded state, the hinge mechanism 1, the first housing 2, and the second housing 3 may support the flexible display. In a process in which the first housing 2 and the second housing 3 rotate relative to each other from the unfolded state to the folded state or from the folded state to the unfolded state, the flexible display may be folded or unfolded with the first housing 2 and the second housing 3.

FIG. 2 is a diagram of a partial exploded structure of the electronic device shown in FIG. 1. In this embodiment of this application, the first housing 2 and the second housing 3 may be located on two opposite sides of the hinge mechanism 1. A side that is of the first housing 2 and that is close to the hinge mechanism 1 is provided with a first accommodating groove 201, and a side that is of the second housing 3 and that is close to the hinge mechanism 1 is provided with a second accommodating groove 301. One side of the hinge mechanism 1 may be partially accommodated in the first accommodating groove 201, and the other side of the hinge mechanism 1 may be partially accommodated in the second accommodating groove 301. The hinge mechanism 1 may include one main shaft unit 11, or may include a plurality of main shaft units 11. FIG. 2 shows a case in which the hinge mechanism 1 includes four main shaft units 11. The four main shaft units 11 may be spaced from each other in a length direction of the hinge mechanism 1. The length direction of the hinge mechanism 1 may be understood as an extension direction of an axis along which the first housing 2 and the second housing 3 rotate around the hinge mechanism 1. The first housing 2 and the second housing 3 may be rotatably connected via the one or more main shaft units 11. This can effectively improve rotation stability of the first housing 2 and the second housing 3 of the electronic device relative to the hinge mechanism 1.

In addition, the hinge mechanism 1 may further include a base 12 disposed in the length direction, and the base 12 may be configured to bear the one or more main shaft units 11. It should be noted that, in some possible implementation solutions, when there are a plurality of main shaft units 11, each of the plurality of main shaft units 11 may use one base 12 as a bearing component, to improve integration of the hinge mechanism 1. In some other possible implementation solutions, the hinge mechanism 1 may be provided with one base 12 corresponding to each main shaft unit 11, so that each main shaft unit 11 uses the corresponding base 12 as a bearing component. In the embodiment shown in FIG. 2, an example in which the hinge mechanism 1 includes an integral base 12 is used for description.

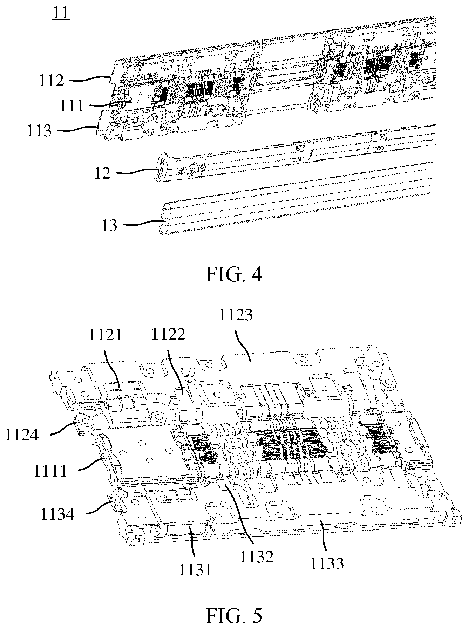

Refer to FIG. 3 and FIG. 4. FIG. 3 is a diagram of a partial structure of the main shaft unit 11 according to an embodiment of this application. FIG. 4 is a diagram of an exploded structure of the main shaft unit 11 shown in FIG. 3. In this embodiment, the main shaft unit 11 may include a module bracket 111 and two rotation modules. The two rotation modules are a first rotation module 112 and a second rotation module 113 respectively. The module bracket 111 may be fastened to the base 12, and may be used as a bearing component of the first rotation module 112 and the second rotation module 113. The first rotation module 112 and the second rotation module 113 are respectively disposed on two sides of the module bracket 111.

In a possible implementation solution, the base 12 may be disposed on a side that is of the hinge mechanism and that is away from the support surface of the hinge mechanism. In addition, the hinge mechanism may further include a cover 13. The cover 13 may cover a side that is of the base 12 and that is away from the support surface of the hinge mechanism. For example, the cover 13 and the base 12 may be but is not limited to being bonded and fastened by using an adhesive. Refer to FIG. 2. When the electronic device is in the unfolded state, the cover 13 is hidden in the first accommodating groove 201 of the first housing 2 and the second accommodating groove 301 of the second housing 3. In this case, an appearance surface of the first housing 2 and an appearance surface of the second housing 3 may jointly form an appearance surface of the electronic device. When the electronic device is switched from the unfolded state to the folded state, as the first housing 2 and the second housing 3 rotate, a surface on a side that is of the cover 13 and that is away from the base 12 is gradually exposed from the first accommodating groove 201 of the first housing 2 and the second accommodating groove 301 of the second housing 3. After the electronic device is switched to the folded state, the appearance surface of the first housing 2, the appearance surface of the second housing 3, and the surface on the side that is of the cover 13 and that is away from the base 12 jointly form the appearance surface of the electronic device.

For ease of description, in the following embodiments of this application, a specific disposing manner of the first rotation module 112 is mainly used as an example to describe the main shaft unit 11. For disposing of the second rotation module 113, refer to disposing of the first rotation module 112. It should be noted that a design of the second rotation module 113 may be completely consistent with that of the first rotation module 112. Alternatively, reference may be made only to only components included in the first rotation module 112 and a connection relationship, and other parameters may be adaptively adjusted, and are not required to be completely consistent.

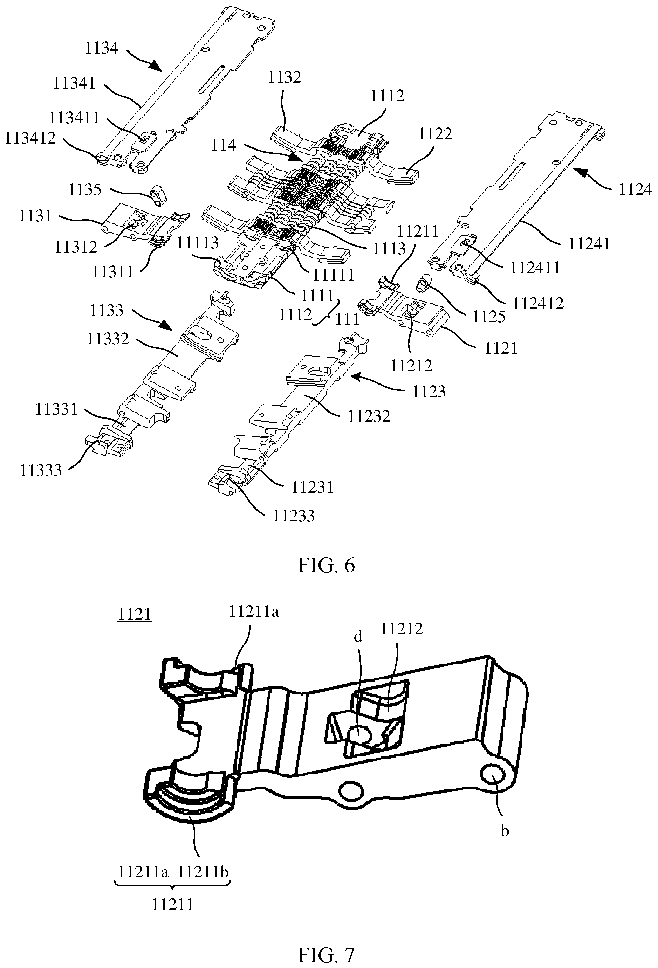

Refer to FIG. 5 and FIG. 6. FIG. 5 is a diagram of a partial structure of the hinge mechanism in the unfolded state according to an embodiment of this application. FIG. 6 is a diagram of a partial exploded structure of the hinge mechanism in the unfolded state according to an embodiment of this application. In this embodiment of this application, the first rotation module 112 may include a first swing arm 1121, a first support arm 1122, a first housing support 1123, and a first door plate 1124. The first door plate 1124 may be configured to support the flexible display, and is fastened to the flexible display. The first swing arm 1121 and the first support arm 1122 may be disposed on a surface that is of the first door plate 1124 and that is away from the flexible display, and the first swing arm 1121 and the first support arm 1122 may be distributed in the length direction of the hinge mechanism, and may be separately rotatably connected to the module bracket 111. The first housing support 1123 may be located on a surface that is of the first swing arm 1121 and that is away from the first door plate 1124 and a surface that is of the first support arm 1122 and that is away from the first door plate 1124. The first housing support 1123 may be fastened to the first housing. The first housing support 1123 may be rotatably connected to the first swing arm 1121 and slidably connected to the first support arm 1122. In unfolding and folding processes of the hinge mechanism, the first housing support rotates synchronously with the first housing, to drive the first swing arm 1121 and the first support arm 1122 to synchronously rotate around the module bracket 111. In addition, the first housing support 1123 may be further rotatably connected to the first door plate 1124, so that in a rotation process of the first housing support 1123, the first door plate 1124 can also rotate based on a specific track, to provide flat support for the flexible display when the hinge mechanism is in the unfolded state, and provide specific screen accommodating space for the flexible display when the hinge mechanism is in the folded state, to ensure reliability of the flexible display.

FIG. 7 is a diagram of a structure of the first swing arm according to an embodiment of this application. Refer to FIG. 6 and FIG. 7. In this embodiment, the module bracket 111 may include a swing arm support 1111, and the first swing arm 1121 may be specifically rotatably connected to the swing arm support 1111. In addition, a rotation axis center of the first swing arm 1121 is disposed in the length direction of the hinge mechanism. During specific implementation, one end that is of the first swing arm 1121 and that is configured to connect to the swing arm support 1111 may be provided with a first arc-shaped rotation block 11211. Correspondingly, the swing arm support 1111 may be provided with a first arc-shaped groove 11111. The first arc-shaped rotation block 11211 of the first swing arm 1121 may be accommodated in the first arc-shaped groove 11111, and may rotate along an arc-shaped surface of the first arc-shaped groove 11111. In this way, the first support arm 1122 rotates around the swing arm support 1111. Such a manner in which an arc-shaped groove cooperates with an arc-shaped rotation block to rotate around an axis center determined by a virtual position may be referred to as a rotation connection manner of a virtual axis. In other words, the two rotation entities do not directly rotate relative to each other via a physical pin shaft, but are rotatably connected via the foregoing cooperation structure. This connection manner helps reduce a volume of the main shaft unit, and helps implement a miniaturization design of the hinge mechanism. The first arc-shaped rotation block 11211 may be but is not limited to a circular-arc-shaped rotation block, and the first arc-shaped groove 11111 may be but is not limited to a circular-arc-shaped groove.

In a specific embodiment, the first arc-shaped rotation block 11211 may include two rotation sub-blocks: a first rotation sub-block 11211a and a second rotation sub-block 11211b, and the first rotation sub-block 11211a and the second rotation sub-block 11211b may be spaced from each other in the length direction of the hinge mechanism. Correspondingly, the first arc-shaped groove 11111 may also include a first arc-shaped sub-groove (not shown in the figure) and a second arc-shaped sub-groove. The first arc-shaped sub-groove and the second arc-shaped sub-groove may also be spaced from each other in the length direction of the hinge mechanism. The first rotation sub-block 11211a may be accommodated in the first arc-shaped sub-groove and may rotate along an arc-shaped surface of the first arc-shaped sub-groove, and the second rotation sub-block 11211b may be accommodated in the second arc-shaped sub-groove and may rotate along an arc-shaped surface of the second arc-shaped sub-groove. Through rotational cooperation between the two rotation sub-blocks and the two arc-shaped sub-grooves, movement stability of the first support arm 1122 relative to the base 12 can be effectively improved.

Certainly, in some other embodiments, the first swing arm 1121 may alternatively be rotatably connected to the swing arm support 1111 via a pin shaft. In this case, a hinged hole may be disposed on each of the first swing arm 1121 and the swing arm support 1111, and the pin shaft is rotatably disposed in the hinged holes of the first swing arm 1121 and the swing arm support 1111.

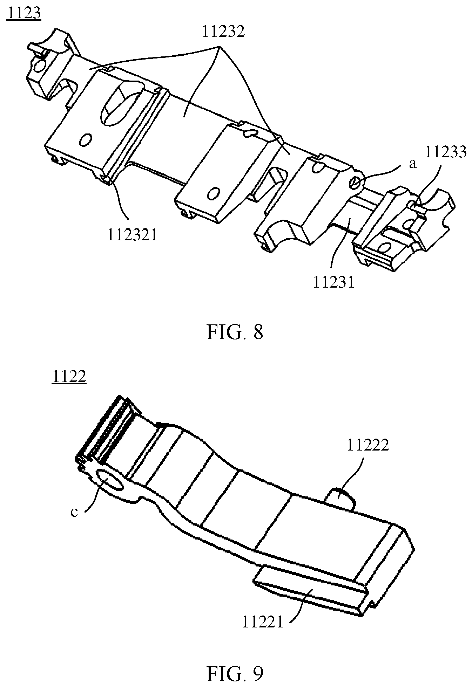

FIG. 8 is a diagram of a structure of the first housing support 1123 according to an embodiment of this application. Refer to FIG. 6 to FIG. 8. A side that is of the first housing support 1123 and that faces the first swing arm 1121 may be provided with a first open slot 11231, and an end that is of the first swing arm 1121 and that is away from the swing arm support 1111 may be disposed in the first open slot 11231. A groove wall of the first open slot 11231 may be provided with a hinged hole a. Correspondingly, the end that is of the first swing arm 1121 and that is away from the swing arm support 1111 may be provided with a hinged hole b. The first swing arm 1121 may be rotatably connected to the first housing support 1123 via a pin shaft rotatably disposed in the hinged hole a of the first swing arm 1121 and the hinged hole b of the first open slot 11231.

FIG. 9 is a diagram of a structure of the first support arm 1122 according to an embodiment of this application. Refer to FIG. 6 and FIG. 9. In this embodiment, the module bracket 111 may further include a damping support 1112 and a pin shaft 1113, and the damping support 1112 and the swing arm support 1111 may be spaced from each other in the length direction of the hinge mechanism. The pin shaft 1113 is connected between the damping support 1112 and the swing arm support 1111, and the pin shaft 1113 is also disposed in the length direction of the hinge mechanism. An end that is of the first support arm 1122 and that is connected to the module bracket 111 is provided with a hinged hole c, and the first support arm 1122 may be sleeved on the pin shaft 1113 through the hinged hole c, to implement a rotating connection with the module bracket 111.

Refer to FIG. 8 and FIG. 9. The first housing support 1123 may be further provided with a first sliding groove 11232, and the first sliding groove 11232 and the first open slot 11231 may be located on a same side of the first housing support 1123. An end that is of the first support arm 1122 and that is away from the module bracket 111 is mounted in the first sliding groove 11232, and can slide in the first sliding groove 11232. In addition, to prevent the first support arm 1122 from falling out of the first sliding groove 11232, a groove wall of the first sliding groove 11232 may be provided with a first sliding rail 112321. Correspondingly, a side surface of the first support arm 1122 may be provided with a first sliding block 11221, and the first sliding block 11221 may be slidably disposed in the first sliding rail 112321. In this way, the first support arm 1122 can be limited in the first sliding groove 11232, and the first sliding rail 112321 may be used to guide sliding of the first support arm 1122 in the first sliding groove 11232, to improve movement stability of the first support arm 1122.

In addition, in some possible embodiments, there may be one or more first support arms 1122. FIG. 6 shows a case in which there are three first support arms 1122, and the three first support arms 1122 may be arranged in the length direction of the hinge mechanism. Correspondingly, the first housing support 1123 may be provided with first sliding grooves 11232 that are in a one-to-one correspondence with the one or more first support arms 1122, and each first support arm 1122 is slidably assembled in a corresponding first sliding groove 11232. The plurality of first support arms 1122 cooperate with the plurality of first sliding grooves 11232, so that stability of a connection between the first support arm 1122 and the first housing support 1123 can be effectively improved, and movement stability of the first housing support 1123 can be further improved.

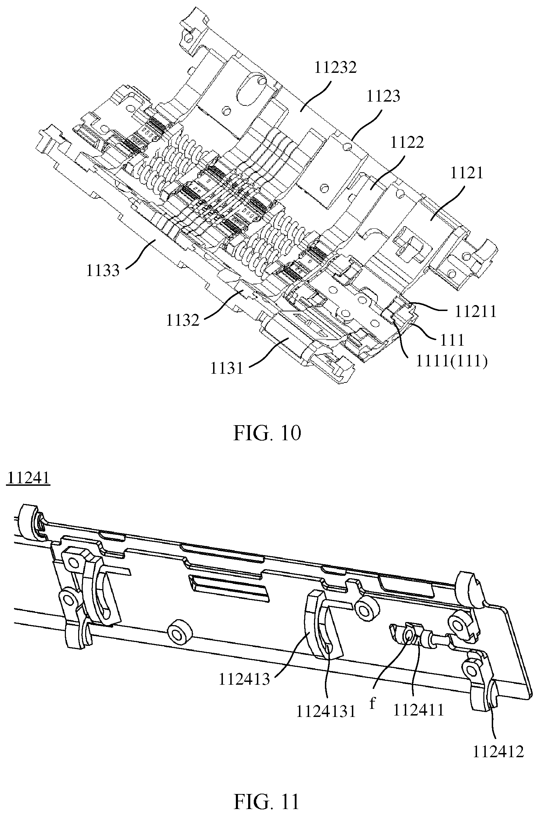

FIG. 10 is a diagram of a partial structure of the main shaft unit according to an embodiment of this application. Refer to FIG. 10. With reference to the foregoing descriptions, it can be learned that the first swing arm 1121, the first housing support 1123, and the first support arm 1122 may roughly form a slider-crank mechanism. When the hinge mechanism is switched from the unfolded state to the folded state, the first housing support 1123 rotates counterclockwise. The first housing support 1123 may drive, based on a rotation connection relationship between the first swing arm 1121 and the first housing support 1123 and a sliding connection relationship between the first support arm 1122 and the first housing support 1123, the first swing arm 1121 and the first support arm 1122 to synchronously rotate counterclockwise around the module bracket 111. A part that is of the first arc-shaped block 11211 of the first swing arm 1121 and that is accommodated in the first arc-shaped groove 11111 of the swing arm support gradually decreases, and a part that is of the first support arm 1122 and that is accommodated in the first sliding groove 11232 of the first housing support 1123 gradually increases. On the contrary, when the hinge mechanism switches from the folded state to the unfolded state, the first housing support 1123 rotates clockwise, and drives the first swing arm 1121 and the first support arm 1122 to synchronously rotate clockwise around the module bracket. The part that is of the first arc-shaped block 11211 of the first swing arm 1121 and that is accommodated in the first arc-shaped groove 11111 of the swing arm support gradually increases, and the part that is of the first support arm 1122 and that is accommodated in the first sliding groove 11232 of the first housing support 1123 gradually decreases.

The foregoing describes the connection relationship between the first housing support 1123 and both the first swing arm 1121 and the first support arm 1122. The following describes a specific disposing manner of the first door plate 1124.

Refer to FIG. 6 again. As described above, the first door plate 1124 may be rotatably connected to the first housing support 1123 and the first swing arm 1121. During specific implementation, the first rotation module 112 may further include a first connecting rod 1125. One end of the first connecting rod 1125 may be rotatably connected to the first swing arm 1121, and the other end of the first connecting rod 1125 may be rotatably connected to the first door plate 1124. In this way, a rotation connection relationship between the first door plate 1124 and the first swing arm 1121 can be implemented via the first connecting rod 1125.

With reference to FIG. 2 and FIG. 6, in a specific implementation, the first door plate 1124 may include a first door plate support 11241 and a first door plate body 11243. The first door plate body 11243 is disposed on a surface that is of the first door plate support 11241 and that faces the flexible display of the electronic device, to support the flexible display. The first door plate support 11241 may be configured to support the first door plate body 11243, and the first door plate 1124 may be rotatably connected to the first housing support 1123 and the first swing arm 1121 via the first door plate support 11241. The first door plate 1124 is designed in a structural form in which the door plate support and the door plate body are separated. This helps reduce processing difficulty of the first door plate and reduce manufacturing costs. For example, the first door plate body 11243 may be fastened to the first door plate support 11241 through, but is not limited to, a screw, press riveting, dispensing, welding, or the like, to improve assembly efficiency of the hinge mechanism.

In some embodiments, the first rotation module may further include a third door plate 11242. The third door plate 11242 may be located on a side that is of the first door plate 1124 and that is close to the module bracket, to jointly support the flexible display with the first door plate 1124. The third door plate 11242 may be rotatably connected to the first door plate 1124, and may be slidably connected to the module bracket 111, and the third door plate 11242 may rotate relative to the module bracket 111.

In addition, in this embodiment of this application, third door plates 11242 of the plurality of main shaft units may be of a separate structure or an integrated structure. Similarly, first door plate bodies 11243 of the plurality of main shaft units may also be designed as a separate structure or an integrated structure. This is not limited in this application. FIG. 4 shows a case in which both the first door plate bodies 11243 and the third door plates 11242 of the plurality of main shaft units are of an integrated structure. This helps improve integration of the hinge mechanism, and simplify assembly difficulty of the hinge mechanism.

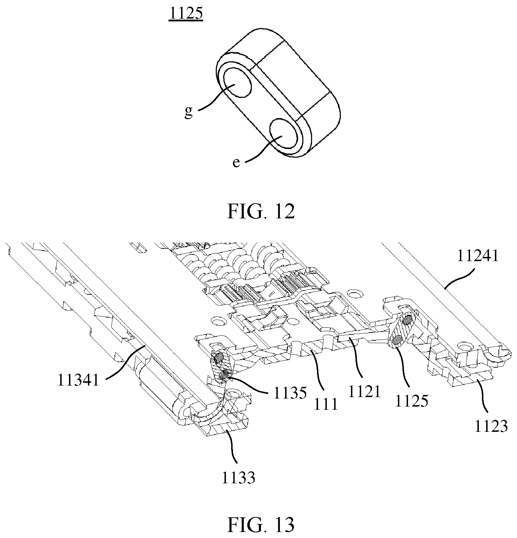

FIG. 11 is a diagram of a structure of the first door plate support 11241 according to an embodiment of this application. FIG. 12 is a diagram of a structure of the first connecting rod 1125 according to an embodiment of this application. Refer to FIG. 7, FIG. 11, and FIG. 12. A surface that is of the first swing arm 1121 and that faces the first door plate support 11241 may be provided with a first mounting groove 11212, and a surface that is of the first door plate support 11241 and that faces the first swing arm 1121 may be provided with a second mounting groove 112411. One end of the first connecting rod 1125 is rotatably disposed in the first mounting groove 11212, and the other end of the first connecting rod 1125 is rotatably disposed in the second mounting groove 112411. During specific implementation, a groove wall of the first mounting groove 11212 may be provided with a hinged hole d, and one end of the first connecting rod is provided with a hinged hole e. The first connecting rod 1125 may be rotatably connected to the first swing arm 1121 via a pin shaft rotatably disposed in the hinged hole e of the first connecting rod 1125 and the hinged hole d of the first mounting groove 11212. Similarly, a groove wall of the second mounting groove 112411 may be provided with a hinged hole f, and the other end of the first connecting rod is provided with a hinged hole g. The first connecting rod 1125 may be rotatably connected to the first door plate support 11241 via a pin shaft rotatably disposed in the hinged hole g of the first connecting rod 1125 and the hinged hole f of the second mounting groove.

Refer to FIG. 8 and FIG. 11. When the first door plate support 11241 is rotatably connected to the first housing support 1123, the first housing support 1123 may be provided with a third arc-shaped rotation block 11233. Correspondingly, a surface that is of the first door plate support 11241 and that faces the first housing support 1123 may be provided with a third arc-shaped groove 112412. The third arc-shaped rotation block 11233 of the first housing support 1123 may be accommodated in the third arc-shaped groove 112412, and can rotate along an arc-shaped surface of the third arc-shaped groove 112412. In this way, a rotation connection relationship between the first housing support 1123 and the first door plate support 11241 can be implemented.

In a specific embodiment, there may be two third arc-shaped rotation blocks 11233, and the two third arc-shaped rotation blocks 11233 may be disposed at two ends of the first housing support 1123 in the length direction of the hinge mechanism. Correspondingly, the first door plate support 11241 may also be provided with two third arc-shaped grooves in the length direction of the hinge mechanism, and the two third arc-shaped rotation blocks 11233 are respectively rotatably disposed in the corresponding third arc-shaped grooves 112412. Through rotational cooperation between the third arc-shaped rotation block 11233 and the third arc-shaped groove 112412, stability of relative movement between the first door plate support 11241 and the first housing support 1123 can be effectively improved.

FIG. 13 is a sectional view of a partial structure of the hinge mechanism according to an embodiment of this application. Refer to FIG. 13. It can be learned with reference to the foregoing description that the first swing arm 1121, the first housing support 1123, the first door plate support 11241, and the first connecting rod 1125 may roughly form a four-bar linkage mechanism based on rotation connection relationships between the first swing arm 1121 and the first housing support 1123, between the first housing support 1123 and the first door plate support 11241, between the first door plate support 11241 and the first connecting rod 1125, and between the first connecting rod 1125 and the first swing arm 1121. When the hinge mechanism is switched from the unfolded state to the folded state, the first housing support 1123 drives the first swing arm 1121 to synchronously rotate counterclockwise, the first swing arm 1121 pulls the first door plate support 11241 via the first connecting rod 1125 in the rotation process, and the first door plate support 11241 also rotates counterclockwise relative to the module bracket 111 under constraint of the first connecting rod 1125 and the first housing support 1123. On the contrary, when the hinge mechanism is switched from the folded state to the unfolded state, the first housing support 1123 drives the first swing arm 1121 to synchronously rotate clockwise, the first swing arm 1121 pushes the first door plate support 11241 via the first connecting rod 1125 in the rotation process, and the first door plate support 11241 also rotates clockwise relative to the module bracket 111 under constraint of the first connecting rod 1125 and the first housing support 1123. A design of this type of four-bar linkage mechanism can effectively improve movement accuracy of the hinge mechanism in the unfolding and folding processes, and can improve a force-bearing state of the first door plate support 11241, thereby improving reliability of an overall structure of the electronic device in which the hinge mechanism is used.

Refer to FIG. 11 again. To improve movement stability of the first door plate support 11241, in some embodiments, a surface that is of the first door plate support 11241 and that is away from the flexible display is further provided with a first bump 112413. The first bump 112413 may be located on a side of the first support arm 1122 in the length direction of the hinge mechanism, for example, may be located on a side that is of the first support arm 1122 and on which the first sliding block 11221 is not disposed (refer to FIG. 9). A surface on the side of the first support arm 1122 may be provided with a first sliding shaft 11222. Correspondingly, a surface that is of the first bump 112413 and that faces the first support arm 1122 may be provided with a first rotary sliding groove 1124131, and the first sliding shaft 11222 may be accommodated in the first rotary sliding groove 1124131, and can slide along the first rotary sliding groove 1124131. In this way, the first door plate support 11241 may be rotatably connected to the first support arm 1122 through cooperation between the first sliding shaft 11222 and the first rotary sliding groove 1124131. In the unfolding and folding processes of the hinge mechanism, the first door plate support 11241 may be jointly driven by the first housing support 1123, the first connecting rod 1125, and the first support arm 1122 to rotate. This helps further improve movement reliability and stability of the first door plate support 11241.

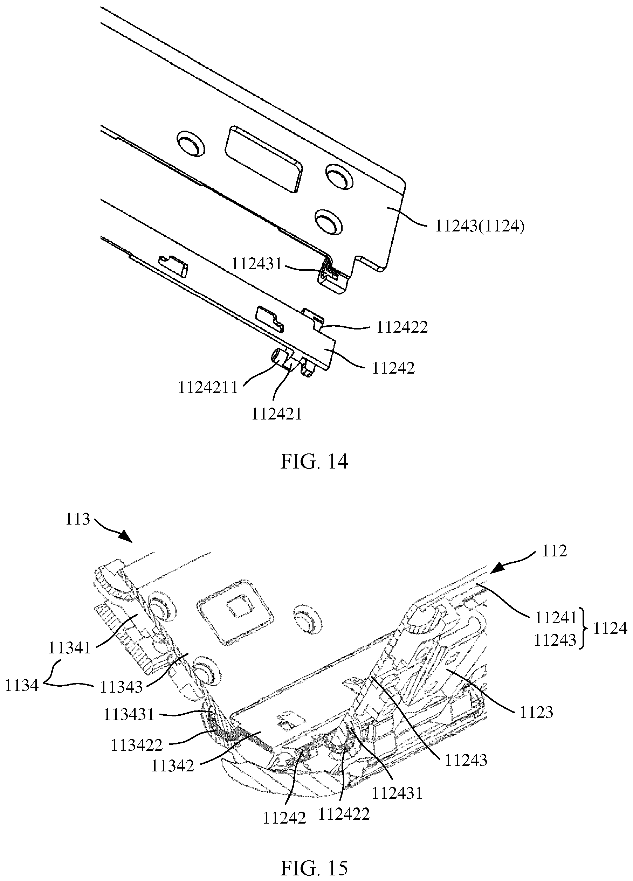

FIG. 14 is a diagram of a structure of the first door plate 1124 and the third door plate 11242 according to an embodiment of this application. FIG. 15 is a sectional view of a partial structure of the hinge mechanism in the intermediate state according to an embodiment of this application. Refer to FIG. 14 and FIG. 15. The third door plate 11242 may be rotatably connected to the first door plate 1124 by using a virtual axis. For example, a surface that is of the third door plate 11242 and that is away from the flexible display may be provided with a fifth arc-shaped rotation block 112422. Correspondingly, a surface that is of the first door plate body 11243 and that is away from the flexible display may be provided with a fifth arc-shaped groove 112431. The fifth arc-shaped block 112422 of the third door plate 11242 may be accommodated in the fifth arc-shaped groove 112431, and can rotate along an arc-shaped surface of the fifth arc-shaped groove 112431. In this way, the third door plate 11242 is rotatably connected to the first door plate body 11243. In this connection manner, in the unfolding and folding processes of the hinge mechanism, a gap generated between the third door plate 11242 and the first door plate 1124 due to relative movement is small, so that effect of supporting the flexible display can be improved.

Certainly, in some other implementations, the third door plate 11242 may alternatively be rotatably connected to the first door plate 1124 via a pin shaft. In this case, the third door plate 11242 and the first door plate body 11243 each may be provided with a pin shaft hole, and the pin shaft is rotatably disposed in the pin shaft hole of the third door plate 11242 and the pin shaft hole of the first door plate body 11243.

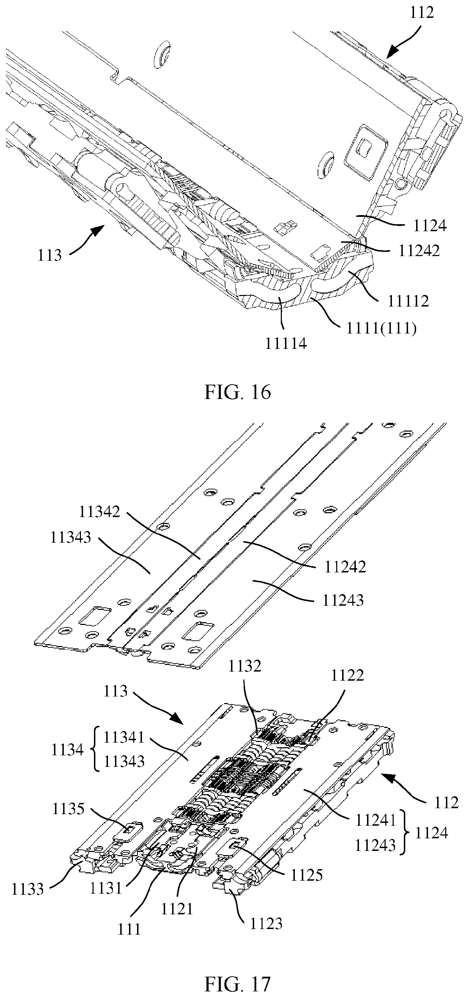

FIG. 16 is a sectional view of another partial structure of the hinge mechanism in an intermediate state according to an embodiment of this application. Refer to FIG. 14 and FIG. 16. When the third door plate 11242 is rotatably connected to the swing arm support 1111, the surface that is of the third door plate 11242 and that is away from the flexible display may be provided with a first extension wall 112421, the first extension wall 112421 is provided with a first fastening shaft 1124211, and the first fastening shaft 1124211 may be disposed in the length direction of the hinge mechanism. Correspondingly, in the length direction of the hinge mechanism, a side that is at an end of the swing arm support 1111 and that is close to the first rotation module 112 may be provided with a first track groove 11112, and the first fastening shaft 1124211 may be disposed in the first track groove 11112, and can slide along the first track groove 11112. In this way, the third door plate 11242 may be rotatably connected to the swing arm support 1111, that is, the third door plate 11242 is rotatably connected to the module bracket 111, through cooperation between the first fastening shaft 1124211 and the first track groove 11112.

As described above, the first rotation module 112 and the second rotation module 113 may be respectively disposed on the two sides of the module bracket 111. Refer to FIG. 6 again. During specific implementation, the second rotation module 113 may also include a second swing arm 1131, a second support arm 1132, a second housing support 1133, a second door plate 1134, and a second connecting rod 1135. The second door plate 1134 may be configured to support the flexible display, and is fastened to the flexible display. The second swing arm 1131 and the second support arm 1132 may be disposed on a side that is of the second door plate 1134 and that is away from the flexible display. The second swing arm 1131 and the second support arm 1132 are distributed in the length direction of the hinge mechanism, and are separately rotatably connected to the module bracket 111. The second housing support 1133 may be located on a surface that is of the second swing arm 1131 and that is away from the second door plate 1134 and a surface that is of the second support arm 1132 and that is away from the second door plate 1134, and may be fastened to the second housing.

With reference to FIG. 6 and FIG. 10, similar to the first swing arm 1121, the second swing arm 1131 may also be rotatably connected to the swing arm support 1111. During specific implementation, an end that is of the second swing arm 1131 and that is configured to connect to the swing arm support 1111 may be provided with a second arc-shaped rotation block 11311. Correspondingly, the swing arm support 1111 may be provided with a second arc-shaped groove 11113, and the second arc-shaped rotation block 11311 may be slidably disposed in the second arc-shaped groove 11113.

A side that is of the second housing support 1133 and that faces the second swing arm 1131 may be provided with a second open slot 11331, and an end that is of the second swing arm 1131 and that is away from the swing arm support 1111 may be disposed in the second open slot 11331. A slot wall of the second open slot 11331 and an end that is of the second swing arm 1131 and that is away from the swing arm support 1111 each are provided with a hinged hole, and the second swing arm 1131 may be rotatably connected to the second housing support 1133 via a pin shaft rotatably disposed in the hinged hole of the second swing arm 1131 and the hinged hole of the second open slot 11331. The second housing support 1133 may be further provided with a second sliding groove 11332, and the second sliding groove 11332 and the second open slot 11331 may be located on a same side of the second housing support 1133. An end that is of the second support arm and that is away from the module bracket is mounted in the second sliding groove, and can slide in the second sliding groove.

In addition, there may alternatively be one or more second support arms 1132, and the plurality of second support arms 1132 may be arranged in the length direction of the hinge mechanism. Correspondingly, the second housing support 1133 may be provided with second sliding grooves 11332 that are in a one-to-one correspondence with the one or more second support arms 1132, and each second support arm 1132 is slidably assembled in a corresponding second sliding groove 11332. In this way, stability of a connection between the second support arm 1132 and the second housing support 1133 is improved through cooperation between the plurality of second support arms 1132 and the plurality of second sliding groove 11332.

Refer to FIG. 4 and FIG. 6. The second door plate 1134 may be rotatably connected to the second housing support 1133 and the second swing arm 1131. During specific implementation, one end of the second connecting rod 1135 may be rotatably connected to the second swing arm 1131, and the other end of the second connecting rod 1135 may be rotatably connected to the second door plate 1134. In this way, a rotation connection relationship between the second door plate 1134 and the second swing arm 1131 can be implemented via the second connecting rod 1135.

The second door plate 1134 may include a second door plate support 11341 and a second door plate body 11343. The second door plate body 11343 is disposed on a surface that is of the second door plate support 11341 and that faces the flexible display of the electronic device, to support the flexible display. For example, the fourth sub-board 11343 may be fastened to the second door plate support 11341 through, but is not limited to, a screw, press riveting, dispensing, welding, or the like.

In addition, the second rotation module may further include a fourth door plate 11342. The fourth door plate 11342 may be located on a side that is of the second door plate 1134 and that is close to the module bracket, to jointly support the flexible display with the second door plate 1134. The fourth door plate 11342 may be rotatably connected to the second door plate 1134, and may be slidably connected to the module bracket 111, and the fourth door plate 11342 may rotate relative to the module bracket 111.

In a specific embodiment, a surface that is of the second swing arm 1131 and that faces the second door plate support 11341 may be provided with a third mounting groove 11312, and a surface that is of the second door plate support 11341 and that faces the second swing arm 1131 may be provided with a fourth mounting groove 113411. One end of the second connecting rod 1135 is rotatably disposed in the third mounting groove 11312, and the other end of the second connecting rod 1135 is rotatably disposed in the fourth mounting groove 113411.

When the second door plate support 11341 is rotatably connected to the second housing support 1133, the second housing support 1133 may be provided with a fourth arc-shaped rotation block 11333. Correspondingly, a surface that is of the second door plate support 11341 and that faces the second housing support 1133 may be provided with a fourth arc-shaped groove 113412. The fourth arc-shaped block 11333 of the second housing support 1133 may be slidably disposed in the fourth arc-shaped groove 113412. In this way, the second housing support 1133 is rotatably connected to the second door plate support 11341.

In addition, a surface that is of the second door plate support and that is away from the flexible display may be further provided with a second bump, and the second bump is located on a side of the second support arm in the length direction of the hinge mechanism. A side surface that is of the second support arm and that faces the second bump may be provided with a second sliding shaft. Correspondingly, a side surface that is of the second bump and that faces the second support arm may be provided with a second rotary sliding groove. The second sliding shaft may be accommodated in the second rotary sliding groove, and can slide along the second rotary sliding groove. In this way, the second door plate support can be rotatably connected to the second support arm through cooperation between the second sliding shaft and the second rotary sliding groove.

Refer to FIG. 15 and FIG. 16. When the fourth door plate 11342 is rotatably connected to the module bracket 111, a surface that is of the fourth door plate 11342 and that is away from the flexible display may be provided with a second extension wall (not shown in the figure), the second extension wall is provided with a second fastening shaft, and the second fastening shaft may be disposed in the length direction of the hinge mechanism. Correspondingly, in the length direction of the hinge mechanism, a side that is at an end of the swing arm support 1111 and that is close to the second rotation module 113 may be provided with a second track groove 11114, and the second fastening shaft may be slidably disposed in the second track groove 11114. In this way, the fourth door plate 11342 is rotatably connected to the module bracket 111.

In addition, the surface that is of the fourth door plate 11342 and that is away from the flexible display may be provided with a sixth arc-shaped rotation block 113421. Correspondingly, a surface that is of the second door plate body 11343 and that is away from the flexible display may be provided with a sixth arc-shaped groove 113431. The sixth arc-shaped rotation block 113421 of the fourth door plate 11342 may be slidably disposed in the sixth arc-shaped groove 113431. In this way, the fourth door plate 11342 is rotatably connected to the second door plate body 11343.

After the structures of and the connection relationships between the first rotation module 112, the second rotation module 113, and the module bracket 111 provided in the foregoing embodiments of this application are understood, the following describes a movement process of the hinge mechanism.

First, FIG. 17 is a diagram of a partial structure of the hinge mechanism in the unfolded state according to an embodiment of this application. When the hinge mechanism is in the unfolded state, the first rotation module 112 and the second rotation module 113 are located on the two sides of the module bracket 111, and an included angle between the first rotation module 112 and the second rotation module 113 is approximately 180 degrees. In this case, a surface that is of the first door plate 1124 and that is away from the first housing support 1123, a surface that is of the third door plate 11242 and that is away from the first housing support 1123, a surface that is of the second door plate 1134 and that is away from the second housing support 1133, and a surface that is of the fourth door plate 11342 and that is away from the second housing support 1133 are coplanar. The plurality of door plates can provide flat support for the flexible display.

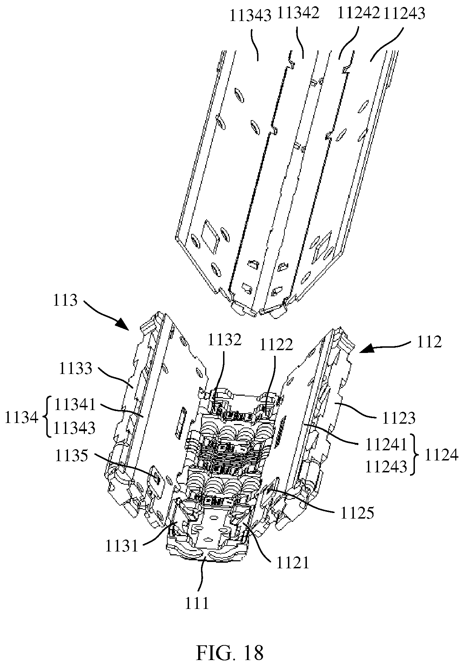

FIG. 18 is a diagram of a partial structure of the hinge mechanism in the intermediate state according to an embodiment of this application. In a process in which the hinge mechanism is switched from the unfolded state to the folded state, the first housing support 1123 rotates counterclockwise, and drives the first swing arm 1121 and the first support arm 1122 to synchronously rotate counterclockwise. The first swing arm 1121 pulls the first door plate 1124 via the first connecting rod 1125 in a rotation process, and the first door plate 1124 rotates counterclockwise under constraint of the first connecting rod 1125 and the first housing support 1123, so that an end that is of the first door plate 1124 and that is close to the module bracket 111 rotates in a direction away from the module bracket 111, and the third door plate 11242 also rotates counterclockwise relative to the module bracket 111 under driving of the first door plate 1124. In this case, an end that is of the third door plate 11242 and that is close to the module bracket 111 may gradually form a specific included angle with the module bracket 111, and an end that is of the third door plate 11242 and that is away from the module bracket 111 (namely, an end close to the first door plate 1124) may rotate in a direction toward the module bracket 111, and gradually form an included angle whose opening faces a side of the second rotation module with the first door plate 1124. Correspondingly, the second housing support 1133 rotates clockwise, and drives the second swing arm 1131 and the second support arm 1132 to synchronously rotate clockwise. The second swing arm 1131 pulls the second door plate 1134 via the second connecting rod 1135 in a rotation process, and the second door plate 1134 rotates clockwise under constraint of the second connecting rod 1135 and the second housing support 1133, so that an end that is of the second door plate 1134 and that is close to the module bracket 111 rotates in a direction away from the module bracket 111, and the fourth door plate 11342 also rotates clockwise relative to the module bracket 111 under driving of the second door plate 1134. In this case, an end that is of the fourth door plate 11342 and that is close to the module bracket 111 may gradually form a specific included angle with the module bracket 111, and an end that is of the fourth door plate 11342 and that is away from the module bracket 111 (namely, an end close to the second door plate) may rotate in a direction toward the module bracket 111, and gradually form an included angle whose opening faces a side of the first rotation module with the second door plate 1134.

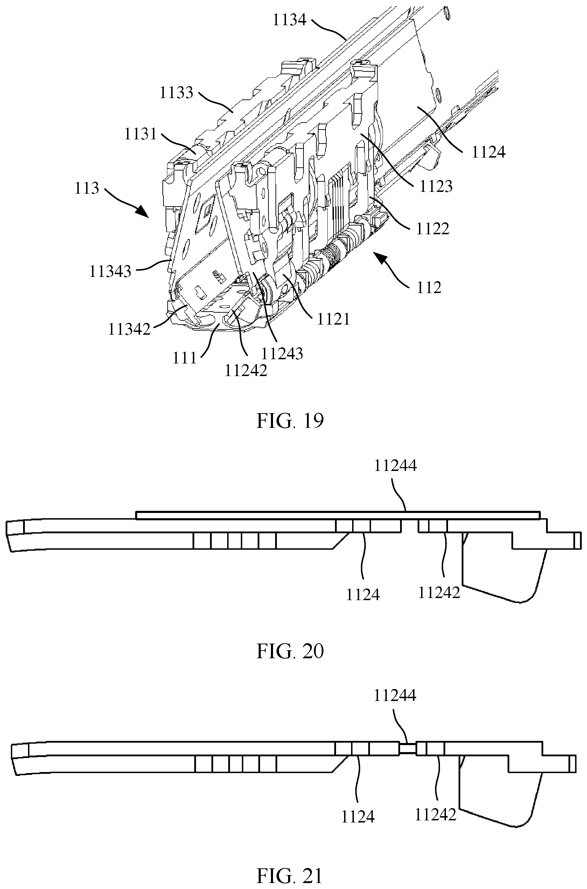

FIG. 19 is a diagram of a partial structure of the hinge mechanism in the folded state according to an embodiment of this application. In a process in which the hinge mechanism changes from the intermediate state shown in FIG. 18 to the folded state shown in FIG. 19, the first housing support 1123 continues to rotate counterclockwise, and jointly pulls, with the first connecting rod 1125, the first door plate 1124 to rotate counterclockwise. The second housing support 1133 continues to rotate clockwise, and jointly pulls, with the second connecting rod 1135, the second door plate 1134 to rotate clockwise until the first door plate 1124 rotates to a first position and the second door plate 1134 rotates to a second position, and therefore, the first housing support 1123 and the second housing support 1133 are approximately opposite to each other. In this case, the hinge mechanism is switched to the folded state. When the hinge mechanism is in the folded state, an included angle may be formed between the first door plate 1124 and the second door plate 1134. Correspondingly, an included angle is also formed between the first door plate 1124 and the third door plate 11242, and an included angle is also formed between the second door plate 1134 and the fourth door plate 11342. In addition, an opening of the included angle formed between the first door plate 1124 and the third door plate 11242 is disposed opposite to an opening of the included angle formed between the second door plate 1134 and the fourth door plate 11342. In this way, the first door plate 1124, the third door plate 11242, the second door plate 1134, the fourth door plate 11342, and the module bracket 111 may jointly form water drop-like screen accommodating space, to meet a bending requirement of the flexible display of the electronic device. This reduces a risk of extrusion or stretching of the flexible display, and prolongs a service life of the flexible display.

It may be understood that, when the hinge mechanism rotates from the folded state shown in FIG. 19 to the unfolded state shown in FIG. 17, the components of the first rotation module 112 and components of the second rotation module 113 may separately perform a movement process reverse to the foregoing descriptions. Details are not described herein.

FIG. 20 is a diagram of another structure of the first door plate 1124 and the third door plate 11242 according to an embodiment of this application. In addition to being connected by using the foregoing virtual axis, the first door plate 1124 and the third door plate 11242 may also be connected via a first flexible component 11244, as shown in FIG. 20. The first door plate 1124 and the third door plate 11242 may rotate relative to each other through deformation of the first flexible component 11244 by using a deformability feature of the first flexible component 11244, so that the first door plate 1124 and the third door plate 11242 can implement a parallel and coplanar connection relationship when the hinge mechanism is in the unfolded state, and can also implement a bending connection relationship at a specific included angle when the hinge mechanism is in the folded state. This meets requirements of the flexible display in different states.

In a specific implementation, the first flexible component 11244 may be disposed on a surface that is of the first door plate body 11243 and that faces the flexible display and a surface that is of the third door plate 11242 and that faces the flexible display, and the first flexible component may be fastened to the first door plate body 11243 and the third door plate 11242 in a bonding manner. For example, the first flexible component 11244 is made of a material including but not limited to carbon fiber, Kevlar, or the like.

FIG. 21 is another diagram of the structure of the first door plate 1124 and the third door plate 11242 according to an embodiment of this application. FIG. 21 also shows an example in which the first door plate 1124 and the third door plate 11242 are connected via the first flexible component 11244. Different from the foregoing embodiment, in this embodiment, the first flexible component 11244 may be connected between the first door plate body 11243 and the third door plate 11242. In this case, the first door plate body 11243 and the third door plate 11242 may be of an integrated structure, and the deformable first flexible component 11244 is formed by performing thinning processing at a joint between the first door plate body 11243 and the third door plate 11242.

Certainly, the second door plate and the fourth door plate may alternatively be connected via a second flexible component. Similarly, the second flexible component may be bonded to a side that is of the second door plate and that is away from the second door plate support and a side that is of the fourth door plate and that is away from the second door plate support, or may be connected between the second door plate and the fourth door plate. Details are not described herein.

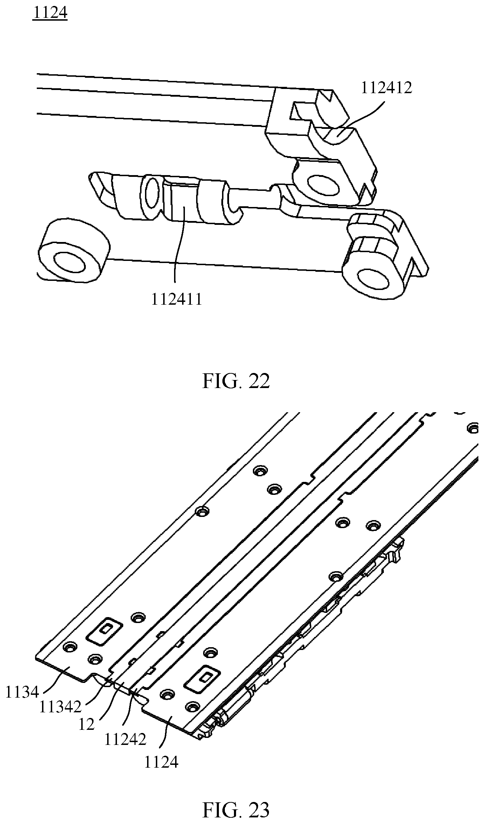

FIG. 22 is a diagram of a structure of the first door plate 1124 according to an embodiment of this application. Refer to FIG. 22. In some possible embodiments of this application, the first door plate body and the first door plate support may alternatively be of an integrated structure. When the first door plate 1124 is rotatably connected to the first housing support 1123, the third arc-shaped groove 112412 that cooperates with the third arc-shaped rotation block 11233 (refer to FIG. 6) of the first housing support 1123 may be directly disposed on the integrated first door plate 1124. In addition, when the first door plate 1124 is rotatably connected to the first swing arm 1121, the second mounting groove 112411 may be disposed on the surface that is of the first door plate 1124 and that is away from the flexible display. In addition, one end of the first connecting rod 1125 is hinged in the second mounting groove 112411, and the other end of the first connecting rod 1125 is hinged in the first mounting groove 11212 of the first swing arm 1121. In this way, the first door plate 1124 is rotatably connected to the first swing arm 1121 via the first connecting rod 1125. This design helps simplify the structure of the first door plate 1124, thereby simplifying the overall structure of the hinge mechanism and reducing assembly difficulty of the hinge mechanism.

Similarly, the second door plate body and the second door plate support may also be of an integrated structure. In this case, when the second door plate is rotatably connected to the second housing support, the fourth arc-shaped groove that cooperates with the fourth arc-shaped rotation block of the second housing support may be directly disposed on the integrated second door plate. In addition, when the second door plate is rotatably connected to the second swing arm, the fourth mounting groove may be disposed on the surface that is of the second door plate and that is away from the flexible display. One end of the second connecting rod is hinged in the fourth mounting groove, and the other end of the second connecting rod is hinged in the third mounting groove of the second swing arm. In this way, the second door plate is rotatably connected via the second connecting rod.

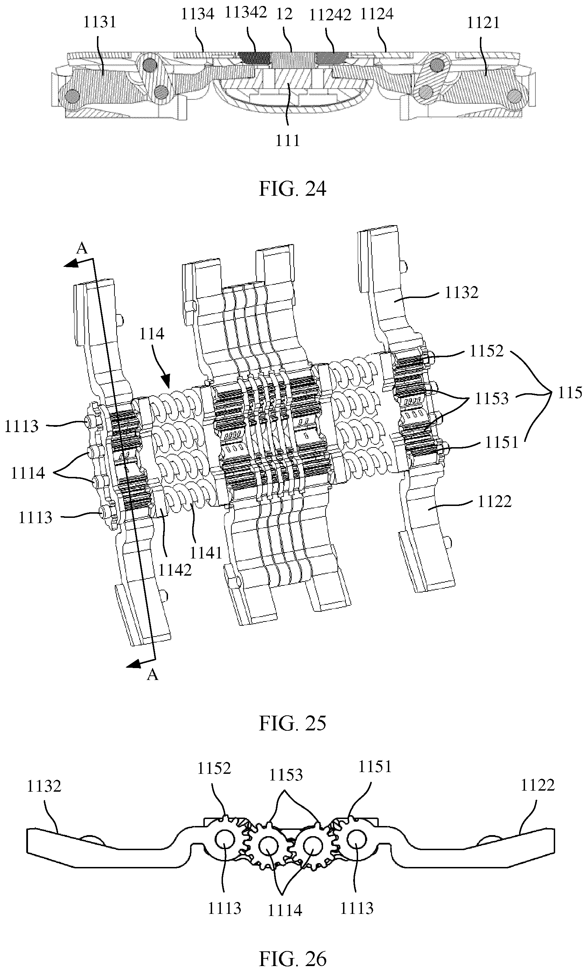

FIG. 23 is a diagram of a partial structure of another hinge mechanism according to an embodiment of this application. FIG. 24 is a sectional view of the hinge mechanism shown in FIG. 23. Refer to FIG. 23 and FIG. 24. In this embodiment, the structures and disposing manners of the first rotation module and the second rotation module are roughly the same as those in the foregoing embodiments. Details are not described herein again. Different from the foregoing embodiment, in this embodiment, the base 12 is no longer disposed on a side that is of the hinge mechanism and that is away from a support surface of the hinge mechanism, but is disposed between the first door plate 1124 and the second door plate 1134. Further, when the first rotation module includes the third door plate 11242 and the second rotation module includes the fourth door plate 11342, the base 12 may be located between the third door plate 11242 and the fourth door plate 11342, and the base 12 may be located on a side that is of the module bracket 111 and that faces the flexible display. When the hinge mechanism is in an unfolded state, a surface that is of the base 12 and that is away from the module bracket 111 may be coplanar with a surface that is of the first door plate 1124 and that is away from the first swing arm 1121, a surface that is of the third door plate 11242 and that is away from the first swing arm 1121, a surface that is of the second door plate 1134 and that is away from the second swing arm, and a surface that is of the fourth door plate 11342 and that is away from the second swing arm 1131. In the unfolded state, surfaces of the base 12, the first door plate 1124, the third door plate 11242, the second door plate 1134, and the fourth door plate 11342 are all located on a same plane. In this case, the base 12 may be considered as a fifth sub-board of the hinge mechanism, and may jointly support the flexible display with the other four sub-boards, to provide better support effect for the flexible display. This further improves use reliability of the flexible display.

Refer to FIG. 6 again. In this embodiment of this application, for better unfolding and folding of the hinge mechanism 1, the hinge mechanism 1 may be further provided with a damping assembly 114 that can provide a damping force for the first rotation module 112 and the second rotation module 113, so that the first rotation module 112 and the second rotation module 113 can stably rotate under an action of the damping force, to prevent the electronic device from being unfolded and folded by mistake, and implement hovering of the two housings at specified positions.

FIG. 25 is a diagram of a partial structure of the hinge mechanism in a folded state according to an embodiment of this application. The damping assembly 114 may include an elastic member 1141 and a conjoined cam 1142. In a length direction of the hinge mechanism, the conjoined cam 1142 may be located between the elastic member, and the first support arm 1122 and the second support arm 1132. An end part that is of the first support arm 1122 and that faces the conjoined cam 1142 may be provided with a first cam surface, and an end part that is of the second support arm 1132 and that faces the conjoined cam 1142 may be provided with a second cam surface. An end part that is of the conjoined cam 1142 and that faces the first support arm 1122 may be provided with a third cam surface, and an end part that is of the conjoined cam 1142 and that faces the second support arm 1132 may be provided with a fourth cam surface. Under an action of the elastic member 1141, the first cam surface presses against the third cam surface, and the second cam surface presses against a cam surface.

In this embodiment of this application, each cam surface includes a plurality of protrusion parts and recessed parts. When slopes of protrusion parts of two cam surfaces are in contact with each other, a damping force that prevents the two cam surfaces from continuing to rotate relative to each other may be generated between the two cam surfaces. Based on this, in a process in which the two support arms rotate around the corresponding pin shaft, the damping assembly 114 may provide a specific damping force for the two support arms, and the damping force may be transferred to the first housing support via the first support arm 1122 and transferred to the second housing support via the second support arm 1132, so that the two housing supports respectively act on the two housings of the electronic device, to reduce a risk of unfolding and folding of the electronic device by mistake, and implement hovering of the two housings at specified positions. In addition, the damping assembly is disposed, so that a user can obtain an obvious operation feeling in a process of unfolding or folding the electronic device. This helps improve user experience.

Still refer to FIG. 25. The hinge mechanism may further include one or more intermediate shafts 1114 that are disposed between the damping support 1112 and the swing arm support 1111 (refer to FIG. 6). The intermediate shafts 1114 may be located between the two pin shafts 1113 hinged by the first support arm 1122 and the second support arm 1132, and the intermediate shafts 1114 may also extend in the length direction of the hinge mechanism. The conjoined cam 1142 may be provided with a plurality of through holes, and the conjoined cam 1142 may be sleeved on the pin shafts 1113 and the intermediate shafts 1114 through the plurality of through holes. The elastic member 1141 may include a plurality of springs that are disposed side by side, and each spring is also sleeved on the pin shaft 1113 and the intermediate shaft 1114, to avoid shifting of the spring during elastic deformation.

In addition, there may be a plurality of groups of damping assemblies 114. For example, in the embodiment shown in FIG. 23, when there are three first support arms 1122 and three second support arms 1132, there may be two groups of damping assemblies 114, and each of the two groups of damping assemblies 114 is disposed between two adjacent first support arms 1122 (or two adjacent second support arms 1132), to provide sufficient damping forces for the first rotation module and the second rotation module. This further improves unfolding or folding reliability of the electronic device.

In addition to the foregoing structure, in some embodiments of this application, the hinge mechanism may further include a synchronization assembly. Still refer to FIG. 24. The synchronization assembly 115 may include a first drive gear 1151 disposed on the first support arm 1122 and a second drive gear 1152 disposed on the second support arm 1132, and the first drive gear 1151 is in transmission connection with the second drive gear 1152. In this way, in a process in which one support arm rotates around the module bracket, the other support arm may be driven to synchronously rotate around the module bracket in a direction toward or away from the one support arm, and the two support arms rotate at a same angle.

FIG. 26 is a sectional view of the hinge mechanism shown in FIG. 25 at A-A. In this embodiment of this application, the synchronization assembly may further include a driven gear 1153, and the driven gear 1153 may be disposed between the two drive gears. In addition, there may be even-numbered driven gears 1153, and a driven gear 1153 and a drive gear that are adjacent to each other and adjacent driven gears 1153 are engaged, so that the two drive gears can synchronously rotate via the even-numbered driven gears 1153. During specific implementation, the driven gear 1153 may be sleeved on the intermediate shaft 1114, to improve movement stability of the synchronization assembly.

In a process in which a support arm rotates around the module bracket, a housing support on a same side as the support arm may be driven to rotate at a same angle, so that the two housing supports can synchronously rotate in a process in which the two support arms synchronously rotate. In addition, because the housing supports may be fastened to the housings of the electronic device, synchronous rotation of the two housing supports may enable the two housings of the electronic device to synchronously rotate. In this way, an instantaneous acting force can be prevented from being applied to the flexible display fastened to the two housings, to help improve reliability of the flexible display.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A hinge mechanism (1), comprising a first rotation module (112), a second rotation module (113), and a module bracket (111), wherein the first rotation module and the second rotation module are respectively disposed on two sides of the module bracket, wherein
the first rotation module comprises a first swing arm (1121), a first support arm (1122), a first housing support (1123), a first door plate (1124), and a first connecting rod (1125), the first door plate is configured to support a flexible display, at least a part of the first swing arm and at least a part of the first support arm are disposed on a surface that is of the first door plate and that is away from the flexible display, the first swing arm and the first support arm are distributed in a length direction of the hinge mechanism, the first swing arm and the first support arm are separately rotatably connected to the module bracket, and a rotation axis center of the first support arm and a rotation axis center of the first swing arm on the module bracket are different from each other and parallel to each other; at least a part of the first housing support is disposed on a surface that is of the first swing arm and that is away from the first door plate and a surface that is of the first support arm and that is away from the first door plate, the first swing arm is rotatably connected to the first housing support, the first support arm is slidably connected to the first housing support, and the first door plate is rotatably connected to the first housing support; and one end of the first connecting rod is rotatably connected to the first swing arm, and the other end of the first connecting rod is rotatably connected to the first door plate;
the second rotation module comprises a second swing arm (1131), a second support arm (1132), a second housing support (1133), a second door plate (1134), and a second connecting rod (1135), the second door plate is configured to support the flexible display, at least a part of the second swing arm and at least a part of the second support arm are disposed on a surface that is of the second door plate and that is away from the flexible display, the second swing arm and the second support arm are distributed in the length direction of the hinge mechanism, the second swing arm and the second support arm are separately rotatably connected to the module bracket, and a rotation axis center of the second support arm and a rotation axis center of the second swing arm on the module bracket are different from each other and parallel to each other; at least a part of the second housing support is disposed on a surface that is of the second swing arm and that is away from the second door plate and a surface that is of the second support arm and that is away from the second door plate, the second swing arm is rotatably connected to the second housing support, the second support arm is slidably connected to the second housing support, and the second door plate is rotatably connected to the second housing support; and one end of the second connecting rod is rotatably connected to the second swing arm, and the other end of the second connecting rod is rotatably connected to the second door plate; and
when the first housing support and the second housing support rotate relative to each other, the first housing support drives the first support arm and the first swing arm to rotate around the module bracket, and the first connecting rod drives the first door plate to rotate relative to the first housing support, for one end that is of the first door plate and that is close to the module bracket to move in a direction away from the module bracket; the second housing support drives the second support arm and the second swing arm to rotate around the module bracket, and the second connecting rod drives the second door plate to rotate relative to the second housing support, for one end that is of the second door plate and that is close to the module bracket to move in a direction away from the module bracket; and when the first door plate rotates to a first position and the second door plate rotates to a second position, the first door plate and the second door plate form an included angle, and jointly enclose, with the module bracket, screen accommodating space used to accommodate the flexible display.

2. The hinge mechanism according to claim 1, wherein a surface that is of the first swing arm and that faces the first door plate is provided with a first mounting groove, a surface that is of the first door plate and that faces the first swing arm is provided with a second mounting groove, one end of the first connecting rod is rotatably disposed in the first mounting groove, and the other end of the first connecting rod is rotatably disposed in the second mounting groove; and
a surface that is of the second swing arm and that faces the second door plate is provided with a third mounting groove, a surface that is of the second door plate and that faces the second swing arm is provided with a fourth mounting groove, one end of the second connecting rod is rotatably disposed in the third mounting groove, and the other end of the second connecting rod is rotatably disposed in the fourth mounting groove.

3. The hinge mechanism according to claim 1 or 2, wherein the surface that is of the first door plate and that is away from the flexible display is provided with a first bump, the first bump is located on a side of the first support arm in the length direction of the hinge mechanism, a side surface that is of the first bump and that faces the first support arm is provided with a first rotary sliding groove, a side surface that is of the first support arm and that faces the first bump is provided with a first sliding shaft, and the first sliding shaft is slidably disposed in the first rotary sliding groove; and
the surface that is of the second door plate and that is away from the flexible display is provided with a second bump, the second bump is located on a side of the second support arm in the length direction of the hinge mechanism, a side surface that is of the second bump and that faces the second support arm is provided with a second rotary sliding groove, a side surface that is of the second support arm and that faces the second bump is provided with a second sliding shaft, and the second sliding shaft is slidably disposed in the second rotary sliding groove.

4. The hinge mechanism according to any one of claims 1 to 3, wherein the two sides of the module bracket are respectively provided with a first arc-shaped groove and a second arc-shaped groove, wherein
the first swing arm has a first arc-shaped rotation block, and the first arc-shaped rotation block is rotatably disposed in the first arc-shaped groove; and
the second swing arm has a second arc-shaped rotation block, and the second arc-shaped rotation block is rotatably disposed in the second arc-shaped groove.

5. The hinge mechanism according to any one of claims 1 to 4, wherein the first housing support is provided with a first sliding groove, and the first support arm is slidably disposed in the first sliding groove; and
the second housing support is provided with a second sliding groove, and the second support arm is slidably disposed in the second sliding groove.

6. The hinge mechanism according to any one of claims 1 to 5, wherein the first housing support is provided with a third arc-shaped rotation block, the first door plate is provided with a third arc-shaped groove, and the third arc-shaped rotation block is rotatably disposed in the third arc-shaped groove; and
the second housing support is provided with a fourth arc-shaped rotation block, the second door plate is provided with a fourth arc-shaped groove, and the fourth arc-shaped rotation block is rotatably disposed in the fourth arc-shaped groove.

7. The hinge mechanism according to any one of claims 1 to 6, wherein the first rotation module further comprises a third door plate, the third door plate is located on a side that is of the first door plate and that is close to the module bracket, and the third door plate is configured to jointly support the flexible display with the first door plate; and the third door plate is rotatably connected to the first door plate, the third door plate is slidably connected to the module bracket, and the third door plate is capable of rotating relative to the module bracket; and
the second rotation module further comprises a fourth door plate, the fourth door plate is located on a side that is of the second door plate and that is close to the module bracket, and the fourth door plate is configured to jointly support the flexible display with the second door plate; and the fourth door plate is rotatably connected to the second door plate, the fourth door plate is slidably connected to the module bracket, and the fourth door plate is capable of rotating relative to the module bracket.

8. The hinge mechanism according to claim 7, wherein a surface that is of the third door plate and that is away from the flexible display is provided with a fifth arc-shaped rotation block, the surface that is of the first door plate and that is away from the flexible display is provided with a fifth arc-shaped groove, and the fifth arc-shaped rotation block is rotatably disposed in the fifth arc-shaped groove; and
a surface that is of the fourth door plate and that is away from the flexible display is provided with a sixth arc-shaped rotation block, the surface that is of the second door plate and that is away from the flexible display is provided with a sixth arc-shaped groove, and the sixth arc-shaped rotation block is rotatably disposed in the sixth arc-shaped groove.

9. The hinge mechanism according to claim 7 or 8, wherein the first door plate is connected to the third door plate via a first flexible component, and the second door plate is connected to the fourth door plate via a second flexible component.

10. The hinge mechanism according to claim 9, wherein the first flexible component is disposed on a surface that is of the first door plate and that faces the flexible display and a surface that is of the third door plate and that faces the flexible display, and the first flexible component is bonded to the first door plate and the third door plate separately; and
the second flexible component is disposed on a surface that is of the second door plate and that faces the flexible display and a surface that is of the fourth door plate and that faces the flexible display, and the second flexible component is bonded to the second door plate and the fourth door plate separately.

11. The hinge mechanism according to claim 9, wherein the first flexible component is connected between the first door plate and the third door plate, and the second flexible component is connected between the second door plate and the fourth door plate.

12. The hinge mechanism according to any one of claims 7 to 11, wherein two sides of an end part of the module bracket are respectively provided with a first track groove and a second track groove;
the surface that is of the third door plate and that is away from the flexible display is provided with a first extension wall, the first extension wall is provided with a first fastening shaft disposed in the length direction of the hinge mechanism, and the first fastening shaft is slidably disposed in the first track groove; and
the surface that is of the fourth door plate and that is away from the flexible display is provided with a second extension wall, the second extension wall is provided with a second fastening shaft disposed in the length direction of the hinge mechanism, and the second fastening shaft is slidably disposed in the second track groove.

13. The hinge mechanism according to any one of claims 1 to 12, wherein the first door plate comprises a first door plate body and a first door plate support, and the first door plate body is fastened to a surface that is of the first door plate support and that faces the flexible display;
the second door plate comprises a second door plate body and a second door plate support, and the second door plate body is fastened to a surface that is of the second door plate support and that faces the flexible display; and
wherein the first door plate body is fastened to the first door plate support, or the first door plate body and the first door plate support are of an integrated structure; and
the second door plate body is fastened to the second door plate support, or the second door plate body and the second door plate support are of an integrated structure.

14. The hinge mechanism according to any one of claims 1 to 13, wherein the hinge mechanism further comprises a base, and the module bracket is fastened to the base;
wherein the base is supported on a surface that is of the module bracket and that is away from the first door plate and the second door plate, and the base is disposed between the first door plate and the second door plate; and
when the hinge mechanism is in an unfolded state, a surface that is of the base and that is away from the module bracket is coplanar with a surface that is of the first door plate and that is away from the first swing arm and a surface that is of the second door plate and that is away from the second swing arm.

15. An electronic device, comprising a first housing, a second housing, a flexible display, and the hinge mechanism according to any one of claims 1 to 14, wherein
the first housing and the second housing are respectively disposed on two sides of the hinge mechanism, the first housing is fastened to the first housing support, and the second housing is fastened to the second housing support; and
the flexible display continuously covers the first door plate, the second door plate, and the hinge mechanism, and the flexible display is fastened to the first door plate and the second door plate.

## Patentansprüche

1. Scharniermechanismus (1), der ein erstes Drehmodul (112), ein zweites Drehmodul (113) und eine Modulhalterung (111) umfasst,
wobei das erste Drehmodul und das zweite Drehmodul jeweils auf zwei Seiten der Modulhalterung angeordnet sind, wobei
das erste Drehmodul einen ersten Schwenkarm (1121), einen ersten Stützarm (1122), eine erste Gehäusestütze (1123), eine erste Türplatte (1124) und eine erste Verbindungsstange (1125) umfasst, wobei die erste Türplatte dazu ausgelegt ist, eine flexible Anzeige zu stützen, mindestens ein Teil des ersten Schwenkarms und mindestens ein Teil des ersten Stützarms auf einer Oberfläche angeordnet sind, die zu der ersten Türplatte gehört und die von der flexiblen Anzeige abgewandt ist, der erste Schwenkarm und der erste Stützarm in einer Längsrichtung des Scharniermechanismus verteilt sind, der erste Schwenkarm und der erste Stützarm separat drehbar mit der Modulhalterung verbunden sind und sich ein Drehachsenzentrum des ersten Stützarms und ein Drehachsenzentrum des ersten Schwenkarms auf der Modulhalterung voneinander unterscheiden und parallel zueinander stehen; wobei mindestens ein Teil der ersten Gehäusestütze auf einer Oberfläche, die zu dem ersten Schwenkarm gehört und die von der ersten Türplatte abgewandt ist, und einer Oberfläche, die zu dem ersten Stützarm gehört und die von der ersten Türplatte abgewandt ist, angeordnet ist, der erste Schwenkarm drehbar mit der ersten Gehäusestütze verbunden ist, der erste Stützarm verschiebbar mit der ersten Gehäusestütze verbunden ist und die erste Türplatte drehbar mit der ersten Gehäusestütze verbunden ist; und wobei ein Ende der ersten Verbindungsstange drehbar mit dem ersten Schwenkarm verbunden ist und das andere Ende der ersten Verbindungsstange drehbar mit der ersten Türplatte verbunden ist;
das zweite Drehmodul einen zweiten Schwenkarm (1131), einen zweiten Stützarm (1132), eine zweite Gehäusestütze (1133), eine zweite Türplatte (1134) und eine zweite Verbindungsstange (1135) umfasst, wobei die zweite Türplatte dazu ausgelegt ist, die flexible Anzeige zu stützen, mindestens ein Teil des zweiten Schwenkarms und mindestens ein Teil des zweiten Stützarms auf einer Oberfläche angeordnet sind, die zu der zweiten Türplatte gehört und die von der flexiblen Anzeige abgewandt ist, der zweite Schwenkarm und der zweite Stützarm in der Längsrichtung des Scharniermechanismus verteilt sind, der zweite Schwenkarm und der zweite Stützarm separat drehbar mit der Modulhalterung verbunden sind und sich ein Drehachsenzentrum des zweiten Stützarms und ein Drehachsenzentrum des zweiten Schwenkarms auf der Modulhalterung voneinander unterscheiden und parallel zueinander stehen; wobei mindestens ein Teil der zweiten Gehäusestütze auf einer Oberfläche, die zu dem zweiten Schwenkarm gehört und die von der zweiten Türplatte abgewandt ist, und einer Oberfläche, die zu dem zweiten Stützarm gehört und die von der zweiten Türplatte abgewandt ist, angeordnet ist, der zweite Schwenkarm drehbar mit der zweiten Gehäusestütze verbunden ist, der zweite Stützarm verschiebbar mit der zweiten Gehäusestütze verbunden ist und die zweite Türplatte drehbar mit der zweiten Gehäusestütze verbunden ist; und wobei ein Ende der zweiten Verbindungsstange drehbar mit dem zweiten Schwenkarm verbunden ist und das andere Ende der zweiten Verbindungsstange drehbar mit der zweiten Türplatte verbunden ist; und
wenn sich die erste Gehäusestütze und die zweite Gehäusestütze relativ zueinander drehen, die erste Gehäusestütze den ersten Stützarm und den ersten Schwenkarm so antreibt, dass sie sich um die Modulhalterung drehen, und die erste Verbindungsstange die erste Türplatte so antreibt, dass sie sich relativ zu der ersten Gehäusestütze dreht, damit sich ein Ende, das zu der ersten Türplatte gehört und das sich nahe der Modulhalterung befindet, in einer Richtung von der Modulhalterung weg bewegt; wobei die zweite Gehäusestütze den zweiten Stützarm und den zweiten Schwenkarm so antreibt, dass sie sich um die Modulhalterung drehen, und die zweite Verbindungsstange die zweite Türplatte so antreibt, dass sie sich relativ zu der zweiten Gehäusestütze dreht, damit sich ein Ende, das zu der zweiten Türplatte gehört und das sich nahe der Modulhalterung befindet, in einer Richtung von der Modulhalterung weg bewegt; und wobei, wenn sich die erste Türplatte in eine erste Position dreht und sich die zweite Türplatte in eine zweite Position dreht, die erste Türplatte und die zweite Türplatte einen eingeschlossenen Winkel bilden und gemeinsam mit der Modulhalterung einen Bildschirmaufnahmeraum umschließen, der zum Aufnehmen der flexiblen Anzeige verwendet wird.

2. Scharniermechanismus nach Anspruch 1, wobei eine Oberfläche, die zu dem ersten Schwenkarm gehört und die der ersten Türplatte zugewandt ist, mit einer ersten Montagenut versehen ist, eine Oberfläche, die zu der ersten Türplatte gehört und die dem ersten Schwenkarm zugewandt ist, mit einer zweiten Montagenut versehen ist, ein Ende der ersten Verbindungsstange drehbar in der ersten Montagenut angeordnet ist und das andere Ende der ersten Verbindungsstange drehbar in der zweiten Montagenut angeordnet ist; und
wobei eine Oberfläche, die zu dem zweiten Schwenkarm gehört und die der zweiten Türplatte zugewandt ist, mit einer dritten Montagenut versehen ist, eine Oberfläche, die zu der zweiten Türplatte gehört und die dem zweiten Schwenkarm zugewandt ist, mit einer vierten Montagenut versehen ist, ein Ende der zweiten Verbindungsstange drehbar in der dritten Montagenut angeordnet ist und das andere Ende der zweiten Verbindungsstange drehbar in der vierten Montagenut angeordnet ist.

3. Scharniermechanismus nach Anspruch 1 oder 2, wobei die Oberfläche, die zu der ersten Türplatte gehört und die von der flexiblen Anzeige abgewandt ist, mit einer ersten Erhebung versehen ist, sich die erste Erhebung auf einer Seite des ersten Stützarms in der Längsrichtung des Scharniermechanismus befindet, eine Seitenfläche, die zu der ersten Erhebung gehört und die dem ersten Stützarm zugewandt ist, mit einer ersten Drehschiebenut versehen ist, eine Seitenfläche, die zu dem ersten Stützarm gehört und die der ersten Erhebung zugewandt ist, mit einer ersten Schiebewelle versehen ist und die erste Schiebewelle verschiebbar in der ersten Drehschiebenut angeordnet ist; und
wobei die Oberfläche, die zu der zweiten Türplatte gehört und die von der flexiblen Anzeige abgewandt ist, mit einer zweiten Erhebung versehen ist, sich die zweite Erhebung auf einer Seite des zweiten Stützarms in der Längsrichtung des Scharniermechanismus befindet, eine Seitenfläche, die zu der zweiten Erhebung gehört und die dem zweiten Stützarm zugewandt ist, mit einer zweiten Drehschiebenut versehen ist, eine Seitenfläche, die zu dem zweiten Stützarm gehört und die der zweiten Erhebung zugewandt ist, mit einer zweiten Schiebewelle versehen ist und die zweite Schiebewelle verschiebbar in der zweiten Drehschiebenut angeordnet ist.

4. Scharniermechanismus nach einem der Ansprüche 1 bis 3, wobei die zwei Seiten der Modulhalterung mit einer ersten bogenförmigen Nut bzw. einer zweiten bogenförmigen Nut versehen sind, wobei
der erste Schwenkarm einen ersten bogenförmigen Drehblock aufweist und der erste bogenförmige Drehblock drehbar in der ersten bogenförmigen Nut angeordnet ist; und
der zweite Schwenkarm einen zweiten bogenförmigen Drehblock aufweist und der zweite bogenförmige Drehblock drehbar in der zweiten bogenförmigen Nut angeordnet ist.

5. Scharniermechanismus nach einem der Ansprüche 1 bis 4, wobei die erste Gehäusestütze mit einer ersten Schiebenut versehen ist und der erste Stützarm verschiebbar in der ersten Schiebenut angeordnet ist; und
wobei die zweite Gehäusestütze mit einer zweiten Schiebenut versehen ist und der zweite Stützarm verschiebbar in der zweiten Schiebenut angeordnet ist.

6. Scharniermechanismus nach einem der Ansprüche 1 bis 5, wobei die erste Gehäusestütze mit einem dritten bogenförmigen Drehblock versehen ist, die erste Türplatte mit einer dritten bogenförmigen Nut versehen ist und der dritte bogenförmige Drehblock drehbar in der dritten bogenförmigen Nut angeordnet ist; und
wobei die zweite Gehäusestütze mit einem vierten bogenförmigen Drehblock versehen ist, die zweite Türplatte mit einer vierten bogenförmigen Nut versehen ist und der vierte bogenförmige Drehblock drehbar in der vierten bogenförmigen Nut angeordnet ist.

7. Scharniermechanismus nach einem der Ansprüche 1 bis 6, wobei das erste Drehmodul ferner eine dritte Türplatte umfasst, sich die dritte Türplatte auf einer Seite befindet, die zu der ersten Türplatte gehört und die sich nahe der Modulhalterung befindet, und die dritte Türplatte dazu ausgelegt ist, die flexible Anzeige gemeinsam mit der ersten Türplatte zu stützen; und wobei die dritte Türplatte drehbar mit der ersten Türplatte verbunden ist, die dritte Türplatte verschiebbar mit der Modulhalterung verbunden ist und sich die dritte Türplatte relativ zu der Modulhalterung drehen kann; und
wobei das zweite Drehmodul ferner eine vierte Türplatte umfasst, sich die vierte Türplatte auf einer Seite befindet, die zu der zweiten Türplatte gehört und die sich nahe der Modulhalterung befindet, und die vierte Türplatte dazu ausgelegt ist, die flexible Anzeige gemeinsam mit der zweiten Türplatte zu stützen; und wobei die vierte Türplatte drehbar mit der zweiten Türplatte verbunden ist, die vierte Türplatte verschiebbar mit der Modulhalterung verbunden ist und sich die vierte Türplatte relativ zu der Modulhalterung drehen kann.

8. Scharniermechanismus nach Anspruch 7, wobei eine Oberfläche, die zu der dritten Türplatte gehört und die von der flexiblen Anzeige abgewandt ist, mit einem fünften bogenförmigen Drehblock versehen ist, die Oberfläche, die zu der ersten Türplatte gehört und die von der flexiblen Anzeige abgewandt ist, mit einer fünften bogenförmigen Nut versehen ist und der fünfte bogenförmige Drehblock drehbar in der fünften bogenförmigen Nut angeordnet ist; und
wobei eine Oberfläche, die zu der vierten Türplatte gehört und die von der flexiblen Anzeige abgewandt ist, mit einem sechsten bogenförmigen Drehblock versehen ist, die Oberfläche, die zu der zweiten Türplatte gehört und die von der flexiblen Anzeige abgewandt ist, mit einer sechsten bogenförmigen Nut versehen ist und der sechste bogenförmige Drehblock drehbar in der sechsten bogenförmigen Nut angeordnet ist.

9. Scharniermechanismus nach Anspruch 7 oder 8, wobei die erste Türplatte über eine erste flexible Komponente mit der dritten Türplatte verbunden ist und die zweite Türplatte über eine zweite flexible Komponente mit der vierten Türplatte verbunden ist.

10. Scharniermechanismus nach Anspruch 9, wobei die erste flexible Komponente auf einer Oberfläche, die zu der ersten Türplatte gehört und die der flexiblen Anzeige zugewandt ist, und einer Oberfläche, die zu der dritten Türplatte gehört und die der flexiblen Anzeige zugewandt ist, angeordnet ist und die erste flexible Komponente separat an die erste Türplatte und die dritte Türplatte gebunden ist; und
wobei die zweite flexible Komponente auf einer Oberfläche, die zu der zweiten Türplatte gehört und die der flexiblen Anzeige zugewandt ist, und einer Oberfläche, die zu der vierten Türplatte gehört und die der flexiblen Anzeige zugewandt ist, angeordnet ist und die zweite flexible Komponente separat an die zweite Türplatte und die vierte Türplatte gebunden ist.

11. Scharniermechanismus nach Anspruch 9, wobei die erste flexible Komponente zwischen der ersten Türplatte und der dritten Türplatte verbunden ist und die zweite flexible Komponente zwischen der zweiten Türplatte und der vierten Türplatte verbunden ist.

12. Scharniermechanismus nach einem der Ansprüche 7 bis 11, wobei zwei Seiten eines Endteils der Modulhalterung jeweils mit einer ersten Führungsnut und einer zweiten Führungsnut versehen sind;
wobei die Oberfläche, die zu der dritten Türplatte gehört und die von der flexiblen Anzeige abgewandt ist, mit einer ersten Verlängerungswand versehen ist, die erste Verlängerungswand mit einer ersten Befestigungswelle versehen ist, die in der Längsrichtung des Scharniermechanismus angeordnet ist, und die erste Befestigungswelle verschiebbar in der ersten Führungsnut angeordnet ist; und
wobei die Oberfläche, die zu der vierten Türplatte gehört und die von der flexiblen Anzeige abgewandt ist, mit einer zweiten Verlängerungswand versehen ist, die zweite Verlängerungswand mit einer zweiten Befestigungswelle versehen ist, die in der Längsrichtung des Scharniermechanismus angeordnet ist, und die zweite Befestigungswelle verschiebbar in der zweiten Führungsnut angeordnet ist.

13. Scharniermechanismus nach einem der Ansprüche 1 bis 12, wobei die erste Türplatte einen ersten Türplattenkörper und eine erste Türplattenstütze umfasst und der erste Türplattenkörper an einer Oberfläche befestigt ist, die zu der ersten Türplattenstütze gehört und die der flexiblen Anzeige zugewandt ist;
wobei die zweite Türplatte einen zweiten Türplattenkörper und eine zweite Türplattenstütze umfasst und der zweite Türplattenkörper an einer Oberfläche befestigt ist, die zu der zweiten Türplattenstütze gehört und die der flexiblen Anzeige zugewandt ist; und
wobei der erste Türplattenkörper an der ersten Türplattenstütze befestigt ist oder der erste Türplattenkörper und die erste Türplattenstütze eine integrierte Struktur bilden; und
wobei der zweite Türplattenkörper an der zweiten Türplattenstütze befestigt ist oder der zweite Türplattenkörper und die zweite Türplattenstütze eine integrierte Struktur bilden.

14. Scharniermechanismus nach einem der Ansprüche 1 bis 13, wobei der Scharniermechanismus ferner eine Basis umfasst und die Modulhalterung an der Basis befestigt ist;
wobei die Basis auf einer Oberfläche gestützt ist, die zu der Modulhalterung gehört und die von der ersten Türplatte und der zweiten Türplatte abgewandt ist, und die Basis zwischen der ersten Türplatte und der zweiten Türplatte angeordnet ist; und
wobei, wenn sich der Scharniermechanismus in einem ausgeklappten Zustand befindet, eine Oberfläche, die zu der Basis gehört und die von der Modulhalterung abgewandt ist, mit einer Oberfläche, die zu der ersten Türplatte gehört und die von dem ersten Schwenkarm abgewandt ist, und einer Oberfläche, die zu der zweiten Türplatte gehört und die von dem zweiten Schwenkarm abgewandt ist, komplanar ist.

15. Elektronisches Gerät, das ein erstes Gehäuse, ein zweites Gehäuse, eine flexible Anzeige und den Scharniermechanismus nach einem der Ansprüche 1 bis 14 umfasst, wobei
das erste Gehäuse und das zweite Gehäuse jeweils auf zwei Seiten des Scharniermechanismus angeordnet sind, das erste Gehäuse an der ersten Gehäusestütze befestigt ist und das zweite Gehäuse an der zweiten Gehäusestütze befestigt ist; und
die flexible Anzeige die erste Türplatte, die zweite Türplatte und den Scharniermechanismus durchgehend bedeckt und die flexible Anzeige an der ersten Türplatte und der zweiten Türplatte befestigt ist.

## Revendications

1. Mécanisme d'articulation (1), comprenant un premier module de rotation (112), un deuxième module de rotation (113), et un support de module (111),
le premier module de rotation et le deuxième module de rotation étant disposés respectivement sur deux côtés du support de module,
le premier module de rotation comprenant un premier bras oscillant (1121), un premier bras de support (1122), un premier support de boîtier (1123), une première plaque de porte (1124) et une première tige de liaison (1125), la première plaque de porte étant configurée pour supporter un affichage flexible, au moins une partie du premier bras oscillant et au moins une partie du premier bras de support étant disposées sur une surface qui est de la première plaque de porte et qui est éloignée de l'affichage flexible, le premier bras oscillant et le premier bras de support étant répartis dans la direction de la longueur du mécanisme d'articulation, le premier bras oscillant et le premier bras de support étant reliés en rotation séparément au support de module, et un centre d'axe de rotation du premier bras de support et un centre d'axe de rotation du premier bras oscillant sur le support de module étant différents l'un de l'autre et parallèles l'un à l'autre ; au moins une partie du premier support de boîtier étant disposée sur une surface qui est du premier bras oscillant et qui est éloignée de la première plaque de porte et sur une surface qui est du premier bras de support et qui est éloignée de la première plaque de porte, le premier bras oscillant étant relié en rotation au premier support de boîtier, le premier bras de support étant relié de manière coulissante au premier support de boîtier, et la première plaque de porte étant reliée en rotation au premier support de boîtier ; et une extrémité de la première tige de liaison étant reliée en rotation au premier bras oscillant, et l'autre extrémité de la première tige de liaison étant reliée en rotation à la première plaque de porte ;
le deuxième module de rotation comprenant un deuxième bras oscillant (1131), un deuxième bras de support (1132), un deuxième support de boîtier (1133), une deuxième plaque de porte (1134) et une deuxième tige de liaison (1135), la deuxième plaque de porte étant configurée pour supporter l'affichage flexible, au moins une partie du deuxième bras oscillant et au moins une partie du deuxième bras de support étant disposées sur une surface qui est de la deuxième plaque de porte et qui est éloignée de l'affichage flexible, le deuxième bras oscillant et le deuxième bras de support étant répartis dans la direction de la longueur du mécanisme d'articulation, le deuxième bras oscillant et le deuxième bras de support étant reliés en rotation séparément au support de module, et un centre d'axe de rotation du deuxième bras de support et un centre d'axe de rotation du deuxième bras oscillant sur le support de module étant différents l'un de l'autre et parallèles l'un à l'autre ; au moins une partie du deuxième support de boîtier étant disposée sur une surface qui est du deuxième bras oscillant et qui est éloignée de la deuxième plaque de porte et sur une surface qui est du deuxième bras de support et qui est éloignée de la deuxième plaque de porte, le deuxième bras oscillant étant relié en rotation au deuxième support de boîtier, le deuxième bras de support étant relié de manière coulissante au deuxième support de boîtier, et la deuxième plaque de porte étant reliée en rotation au deuxième support de boîtier ; et une extrémité de la deuxième tige de liaison étant reliée en rotation au deuxième bras oscillant, et l'autre extrémité de la deuxième tige de liaison étant reliée en rotation à la deuxième plaque de porte ; et
lorsque le premier support de boîtier et le deuxième support de boîtier tournent l'un par rapport à l'autre, le premier support de boîtier entraînant le premier bras de support et le premier bras oscillant pour tourner autour du support de module, et la première tige de liaison entraînant la première plaque de porte en rotation par rapport au premier support de boîtier, pour qu'une extrémité qui est de la première plaque de porte et qui est proche du support de module se déplace dans une direction s'écartant du support de module ; le deuxième support de boîtier entraînant le deuxième bras de support et le deuxième bras oscillant pour tourner autour du support de module, et la deuxième tige de liaison entraînant la deuxième plaque de porte pour tourner par rapport au deuxième support de boîtier, pour qu'une extrémité qui est de la deuxième plaque de porte et qui est proche du support de module se déplace dans une direction opposée au support de module ; et lorsque la première plaque de porte tourne vers une première position et que la deuxième plaque de porte tourne vers une deuxième position, la première plaque de porte et la deuxième plaque de porte forment un angle inclus, et entourent conjointement, avec le support de module, un espace de logement d'écran utilisé pour loger l'affichage flexible.

2. Mécanisme d'articulation selon la revendication 1, une surface qui est du premier bras oscillant et qui fait face à la première plaque de porte étant pourvue d'une première rainure de montage, une surface qui est de la première plaque de porte et qui fait face au premier bras oscillant étant pourvue d'une deuxième rainure de montage, une extrémité de la première tige de liaison étant disposée en rotation dans la première rainure de montage, et l'autre extrémité de la première tige de liaison étant disposée en rotation dans la deuxième rainure de montage ; et
une surface qui est du deuxième bras oscillant et qui fait face à la deuxième plaque de porte étant pourvue d'une troisième rainure de montage, une surface qui est de la deuxième plaque de porte et qui fait face au deuxième bras oscillant étant pourvue d'une quatrième rainure de montage, une extrémité de la deuxième tige de liaison étant disposée en rotation dans la troisième rainure de montage et l'autre extrémité de la deuxième tige de liaison étant disposée en rotation dans la quatrième rainure de montage.

3. Mécanisme d'articulation selon la revendication 1 ou 2, la surface qui est de la première plaque de porte et qui est éloignée de l'affichage flexible étant pourvue d'un premier bossage, le premier bossage étant situé sur un côté du premier bras de support dans la direction de la longueur du mécanisme d'articulation, une surface latérale qui est du premier bossage et qui fait face au premier bras de support étant pourvue d'une première rainure coulissante rotative, une surface latérale qui est du premier bras de support et qui fait face au premier bossage étant pourvue d'un premier arbre coulissant, et le premier arbre coulissant étant disposé de manière coulissante dans la première rainure coulissante rotative ; et
la surface qui est de la deuxième plaque de porte et qui est éloignée de l'affichage flexible étant pourvue d'un deuxième bossage, le deuxième bossage étant situé sur un côté du deuxième bras de support dans la direction de la longueur du mécanisme d'articulation, une surface latérale qui est du deuxième bossage et qui fait face au deuxième bras de support étant pourvue d'une deuxième rainure coulissante rotative, une surface latérale qui est du deuxième bras de support et qui fait face au deuxième bossage étant pourvue d'un deuxième arbre coulissant, et le deuxième arbre coulissant étant disposé de manière coulissante dans la deuxième rainure coulissante rotative.

4. Mécanisme d'articulation selon l'une quelconque des revendications 1 à 3, les deux côtés du support de module étant respectivement pourvus d'une première rainure en forme d'arc et d'une deuxième rainure en forme d'arc,
le premier bras oscillant ayant un premier bloc rotatif en forme d'arc, et le premier bloc rotatif en forme d'arc étant disposé en rotation dans la première rainure en forme d'arc ; et
le deuxième bras oscillant ayant un deuxième bloc rotatif en forme d'arc, et le deuxième bloc rotatif en forme d'arc étant disposé en rotation dans la deuxième rainure en forme d'arc.

5. Mécanisme d'articulation selon l'une quelconque des revendications 1 à 4, le premier support de boîtier étant pourvu d'une première rainure coulissante, et le premier bras de support étant disposé de manière coulissante dans la première rainure coulissante ; et
le deuxième support de boîtier étant pourvu d'une deuxième rainure coulissante, et le deuxième bras de support étant disposé de manière coulissante dans la deuxième rainure coulissante.

6. Mécanisme d'articulation selon l'une quelconque des revendications 1 à 5, le premier support de boîtier étant pourvu d'un troisième bloc de rotation en forme d'arc, la première plaque de porte étant pourvue d'une troisième rainure en forme d'arc, et le troisième bloc de rotation en forme d'arc étant disposé en rotation dans la troisième rainure en forme d'arc ; et
le deuxième support de boîtier étant pourvu d'un quatrième bloc de rotation en forme d'arc, la deuxième plaque de porte étant pourvue d'une quatrième rainure en forme d'arc, et le quatrième bloc de rotation en forme d'arc étant disposé en rotation dans la quatrième rainure en forme d'arc.

7. Mécanisme d'articulation selon l'une quelconque des revendications 1 à 6, le premier module de rotation comprenant en outre une troisième plaque de porte, la troisième plaque de porte étant située sur un côté qui est de la première plaque de porte et qui est proche du support de module, et la troisième plaque de porte étant configurée pour supporter conjointement l'affichage flexible avec la première plaque de porte ; et la troisième plaque de porte étant reliée en rotation à la première plaque de porte, la troisième plaque de porte étant reliée de manière coulissante au support de module, et la troisième plaque de porte étant capable de tourner par rapport au support de module ; et
le deuxième module de rotation comprenant en outre une quatrième plaque de porte, la quatrième plaque de porte étant située sur un côté qui est de la deuxième plaque de porte et qui est proche du support de module, et la quatrième plaque de porte étant configurée pour supporter conjointement l'affichage flexible avec la deuxième plaque de porte ; et la quatrième plaque de porte étant reliée en rotation à la deuxième plaque de porte, la quatrième plaque de porte étant reliée de manière coulissante au support de module, et la quatrième plaque de porte étant capable de tourner par rapport au support de module.

8. Mécanisme d'articulation selon la revendication 7, une surface qui est de la troisième plaque de porte et qui est éloignée de l'affichage flexible étant pourvue d'un cinquième bloc de rotation en forme d'arc, la surface qui est de la première plaque de porte et qui est éloignée de l'affichage flexible étant pourvue d'une cinquième rainure en forme d'arc, et le cinquième bloc de rotation en forme d'arc étant disposé en rotation dans la cinquième rainure en forme d'arc ; et
une surface qui est de la quatrième plaque de porte et qui est éloignée de l'affichage flexible étant pourvue d'un sixième bloc de rotation en forme d'arc, la surface qui est de la deuxième plaque de porte et qui est éloignée de l'affichage flexible étant pourvue d'une sixième rainure en forme d'arc, et le sixième bloc de rotation en forme d'arc étant disposé en rotation dans la sixième rainure en forme d'arc.

9. Mécanisme d'articulation selon la revendication 7 ou 8, la première plaque de porte étant reliée à la troisième plaque de porte par l'intermédiaire d'un premier composant flexible, et la deuxième plaque de porte étant reliée à la quatrième plaque de porte par l'intermédiaire d'un deuxième composant flexible.

10. Mécanisme d'articulation selon la revendication 9, le premier composant flexible étant disposé sur une surface qui est de la première plaque de porte et qui fait face à l'affichage flexible et sur une surface qui est de la troisième plaque de porte et qui fait face à l'affichage flexible, et le premier composant flexible étant lié séparément à la première plaque de porte et à la troisième plaque de porte ; et
le deuxième composant flexible étant disposé sur une surface qui est de la deuxième plaque de porte et qui fait face à l'affichage flexible et sur une surface qui est de la quatrième plaque de porte et qui fait face à l'affichage flexible, et le deuxième composant flexible étant lié séparément à la deuxième plaque de porte et à la quatrième plaque de porte.

11. Mécanisme d'articulation selon la revendication 9, le premier composant flexible étant relié entre la première plaque de porte et la troisième plaque de porte, et le deuxième composant flexible étant relié entre la deuxième plaque de porte et la quatrième plaque de porte.

12. Mécanisme d'articulation selon l'une quelconque des revendications 7 à 11, deux côtés d'une partie d'extrémité du support de module étant respectivement pourvus d'une première rainure de piste et d'une deuxième rainure de piste ;
la surface qui est de la troisième plaque de porte et qui est éloignée de l'affichage flexible étant pourvue d'une première paroi d'extension, la première paroi d'extension étant pourvue d'un premier axe de fixation disposé dans la direction de la longueur du mécanisme d'articulation, et le premier axe de fixation étant disposé de manière coulissante dans la première rainure de piste ; et
la surface qui est de la quatrième plaque de porte et qui est éloignée de l'affichage flexible étant pourvue d'une deuxième paroi d'extension, la deuxième paroi d'extension étant pourvue d'un deuxième axe de fixation disposé dans la direction de la longueur du mécanisme d'articulation, et le deuxième axe de fixation étant disposé de manière coulissante dans la deuxième rainure de piste.

13. Mécanisme d'articulation selon l'une quelconque des revendications 1 à 12, la première plaque de porte comprenant un premier corps de plaque de porte et un premier support de plaque de porte, et le premier corps de plaque de porte étant fixé à une surface qui est du premier support de plaque de porte et qui fait face à l'affichage flexible ;
la deuxième plaque de porte comprenant un deuxième corps de plaque de porte et un deuxième support de plaque de porte, et le deuxième corps de plaque de porte étant fixé à une surface qui est du deuxième support de plaque de porte et qui fait face à l'affichage flexible ; et
le premier corps de plaque de porte étant fixé au premier support de plaque de porte, ou le premier corps de plaque de porte et le premier support de plaque de porte étant d'une structure intégrée ; et
le deuxième corps de plaque de porte étant fixé au deuxième support de plaque de porte, ou le deuxième corps de plaque de porte et le deuxième support de plaque de porte étant d'une structure intégrée.

14. Mécanisme d'articulation selon l'une quelconque des revendications 1 à 13, le mécanisme d'articulation comprenant en outre une base, et le support de module étant fixé à la base ;
la base étant supportée sur une surface qui est du support de module et qui est éloignée de la première plaque de porte et de la deuxième plaque de porte, et la base étant disposée entre la première plaque de porte et la deuxième plaque de porte ; et
lorsque le mécanisme d'articulation est dans un état déplié, une surface qui est de la base et qui est éloignée du support de module est coplanaire avec une surface qui est de la première plaque de porte et qui est éloignée du premier bras oscillant et une surface qui est de la deuxième plaque de porte et qui est éloignée du deuxième bras oscillant.

15. Dispositif électronique, comprenant un premier boîtier, un deuxième boîtier, un affichage flexible, et le mécanisme d'articulation selon l'une quelconque des revendications 1 à 14,
le premier boîtier et le deuxième boîtier étant disposés respectivement sur deux côtés du mécanisme d'articulation, le premier boîtier étant fixé au premier support de boîtier, et le deuxième boîtier étant fixé au deuxième support de boîtier ; et
l'affichage flexible recouvrant en continu la première plaque de porte, la deuxième plaque de porte et le mécanisme d'articulation, et l'affichage flexible étant fixé à la première plaque de porte et à la deuxième plaque de porte.
